# EUROPEAN PATENT APPLICATION

(11) **EP 4 517 824 A1**
(43) Date of publication of application: **05.03.2025**
(21) Application number: 24182085.1
(22) Date of filing: 13.06.2024
(51) Int. Cl.: H01L 25/075, H01L 25/16, H01L 33/54, H01L 33/62

(54) **DISPLAY DEVICE AND TILED DISPLAY DEVICE**

(30) Priority: 28.08.2023 KR 20230113153
(71) Applicant: Samsung Display Co., Ltd., Yongin-si, Gyeonggi-do 17113 (KR)
(72) Inventor: EOM, Ki Chang, 17113 Yongin-si (KR); YANG, Hui Won, 17113 Yongin-si (KR); LEE, Jae Phil, 17113 Yongin-si (KR)
(74) Representative: Marks & Clerk LLP

(57) **Abstract**

A display device includes pixels spaced from each other by a first separation distance in a plan view. A transistor is on a base layer. A first organic layer, a second organic layer, and a third organic layer are sequentially located on the transistor. A light emitting element is on the third organic layer and is electrically connected to the transistor. An outermost pixel that is nearest to an edge of the base layer from among the pixels is spaced from the edge of the base layer by a distance within a second separation distance, the second separation distance being less than the first separation distance. At least one of the second organic layer or the third organic layer clads the first organic layer near the edge of the base layer.

## Description

### BACKGROUND

### 1. Field

The disclosure relates to a display device and a tiled display device.

### 2. Description of the Related Art

A tiled display device may be implemented by stitching a plurality of display panels, and when a dead space exists in each display panel, a boundary between the display panels may be visually recognized, and display quality of an image displayed on the tiled display device may be deteriorated.

### SUMMARY

Aspects of embodiments of the present disclosure provide a display device and a tiled display device with improved stability.

Aspects and features of embodiments of the present disclosure are not limited to the above-described aspects and features, and other technical aspects and features that are not described will be clearly understood by those skilled in the art from the following description.

According to one or more embodiments of the present disclosure, a display device includes pixels spaced from each other by a first separation distance in a plan view. Each of the pixels includes a transistor on a base layer, a first organic layer on the transistor, a second organic layer on the first organic layer, a third organic layer on the second organic layer, and a light emitting element on the third organic layer and electrically connected to the transistor. An outermost pixel that is nearest to an edge of the base layer among the pixels is spaced from the edge of the base layer by a distance within a second separation distance, the second separation distance being less than the first separation distance. At least one of the second organic layer or the third organic layer clads the first organic layer near the edge of the base layer.

In a plan view, the second organic layer or the third organic layer may be extended by a distance equal to or greater than an average thickness of the first organic layer than the first organic layer toward the edge of the base layer.

In a plan view, an organic structure may not be located between the second organic layer or the third organic layer and the edge of the base layer.

The second organic layer may be directly on the first organic layer, the third organic layer may be directly on the second organic layer, and an inorganic layer may not be located between the first to third organic layers.

The display device may further include a first conductive pattern located between the first organic layer and the second organic layer, a second conductive pattern located between the second organic layer and the third organic layer, and a first pixel electrode located on the third organic layer. The light emitting element may be electrically connected to the transistor through the first pixel electrode, the second conductive pattern, and the first conductive pattern, a residue of the first conductive pattern may be at an edge of the first organic layer, and the residue of the first conductive pattern may be covered by the second organic layer or the third organic layer.

The display device may further include a second pixel electrode on the third organic layer and an inorganic layer partially covering the second pixel electrode. In a cross-sectional view, the second pixel electrode may overlap the first conductive pattern and may be spaced from the first conductive pattern by a distance equal to or greater than an average thickness of the second organic layer or the third organic layer.

The first organic layer, the second organic layer, and the third organic layer may include a same organic material.

An edge of the second organic layer or the third organic layer may be in contact with a first surface of the base layer, and an angle between the edge of the second organic layer or the third organic layer and the first surface of the base layer may be within a range of about 35 degrees to about 45 degrees.

Each of the pixels may include a plurality of sub-pixels, each of the sub-pixels may include the light emitting element in an emission area of the pixel. Based on the emission area, the pixels may be spaced from each other by the first separation distance, and the outermost pixel may be spaced from the edge of the base layer by the distance within the second separation distance.

The light emitting element may be a flip chip type of micro light emitting diode element.

In a plan view, the second organic layer may cover the first organic layer.

In a plan view, the third organic layer may cover the second organic layer.

In a plan view, the third organic layer may not cover the second organic layer, and an edge of the second organic layer may be exposed by the third organic layer.

An edge of the first organic layer may be exposed by the second organic layer, and the third organic layer may cover the edge of the first organic layer.

According to one or more embodiments of the present disclosure, a tiled display device includes a plurality of display devices and a seam located between the plurality of display devices. A first display device from among the plurality of display devices includes pixels spaced from each other by a first separation distance in a plan view. Each of the pixels includes a transistor on a base layer, a first organic layer on the transistor, a second organic layer on the first organic layer, a third organic layer on the second organic layer, and a light emitting element on the third organic layer and electrically connected to the transistor. An outermost pixel that is nearest to an edge of the base layer from among the pixels is spaced from the edge of the base layer by a distance within a second separation distance, the second separation distance being less than the first separation distance. The second organic layer or the third organic layer clads the first organic layer near the edge of the base layer.

The light emitting element may be a flip chip type of micro light emitting diode element.

The base layer may be a glass substrate.

The first display device may further include a pad on a first surface of the base layer, and a side surface line on the first surface of the base layer, a second surface opposite to the first surface, and one side surface between the first surface and the second surface, and connected to the pad.

The first display device may further include a connection line on the second surface of the base layer, and a flexible film connected to the connection line through a conductive adhesive member, and the side surface line is connected to the connection line.

The plurality of display devices may be arranged in a matrix form in M rows and N columns.

At least some of the above and other features of the invention are set out in the claims.

Details of other embodiments are included in the detailed description and drawings.

The display device and the tiled display device according to embodiments of the disclosure may include the first to third organic layers (or first to third via layers) between the transistor and the light emitting element, and an inorganic layer may not exist between the first to third organic layers. Therefore, a defect may not occur in adhesion between the first to third organic layers.

In addition, the first to third organic layers may have a clad structure. The second organic layer or the third organic layer may cover not only a lower organic layer, but also a lower conductive pattern (or a source metal layer) and a residue thereof. Therefore, a defect (for example, a short circuit caused by the conductive pattern (or the source metal layer) and the residue thereof may be prevented.

Furthermore, a taper angle of the second organic layer and the third organic layer may be within a range of about 35 degrees to about 45 degrees, and the second organic layer or the third organic layer may cover the first organic layer by about 9 µm to about 10 µm. Therefore, while implementing a negative dead space, a defect due to the residue may be more securely prevented.

An effect according to embodiments is not limited by the contents illustrated above, and more various effects are included in the present specification.

### BRIEF DESCRIPTION OF DRAWINGS

The above and other aspects and features of embodiments of the present disclosure will become more apparent by describing in further detail embodiments thereof with reference to the accompanying drawings, in which:
FIG. 1 is a plan view illustrating a display device according to one or more embodiments;
FIG. 2 is a diagram illustrating an example of a pixel of FIG. 1;
FIG. 3 is a diagram illustrating another example of the pixel of FIG. 1;
FIG. 4 is a circuit diagram illustrating an example of a sub-pixel included in the pixel of FIGS. 2 and 3;
FIG. 5 is a plan view illustrating an embodiment of the display device of FIG. 1;
FIG. 6 is a diagram illustrating a connection relationship between a pixel circuit and a stage included in the display device of FIG. 5;
FIG. 7 is a cross-sectional view illustrating an embodiment of the display device of FIG. 1;
FIG. 8 is a cross-sectional view illustrating an embodiment of the display device of FIG. 1;
FIG. 9 is a cross-sectional view illustrating a comparative example of the display device of FIG. 1;
FIGS. 10 and 11 are cross-sectional views illustrating another embodiment of the display device of FIG. 1;
FIG. 12 is a perspective view illustrating a tiled display device including a plurality of display devices according to one or more embodiments;
FIG. 13 is an enlarged view of an area AA of FIG. 12;
FIG. 14 is a cross-sectional view illustrating an example of a tiled display device taken along the line J-J' of FIG. 13;
FIG. 15 is an enlarged view of an area BB of FIG. 12;
FIG. 16 is a cross-sectional view illustrating an example of a tiled display device taken along the line N-N' of FIG. 15; and
FIG. 17 is a block diagram illustrating a tiled display device according to one or more embodiments.

### DETAILED DESCRIPTION

The present disclosure may be modified in various manners and have various forms. Therefore, embodiments will be illustrated in the drawings and will be described in detail in the specification. However, it should be understood that the present disclosure is not intended to be limited to the disclosed specific forms, and the present disclosure includes all modifications, equivalents, and substitutions within the technical scope of the present disclosure.

Terms of "first", "second", and the like may be used to describe various components, but the components should not be limited by the terms. The terms are used only for the purpose of distinguishing one component from another component. For example, without departing from the scope of the present disclosure, a first component may be referred to as a second component, and similarly, a second component may also be referred to as a first component. In the following description, the singular expressions include plural expressions unless the context clearly dictates otherwise.

It should be understood that in the present application, a term of "include", "have", and/or the like is used to specify that there is a feature, a number, a step, an operation, a component, a part, or a combination thereof described in the specification, but does not exclude a possibility of the presence or addition of one or more other features, numbers, steps, operations, components, parts, or combinations thereof in advance. In addition, a case where a portion of a layer, a layer, an area, a plate, or the like is referred to as being "on" another portion, it includes not only a case where the portion is "directly on" another portion, but also a case where there is further another portion between the portion and another portion. In addition, in the present disclosure, when a portion of a layer, a layer, an area, a plate, or the like is formed on another portion, a forming direction is not limited to an upper direction but includes forming the portion on a side surface or in a lower direction. On the contrary, when a portion of a layer, a layer, an area, a plate, or the like is formed "under" another portion, this includes not only a case where the portion is "directly beneath" another portion but also a case where there is further another portion between the portion and another portion.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

The aspects and features of embodiments of the present disclosure and a method of achieving them will become apparent with reference to the embodiments described in detail later together with the accompanying drawings. However, the present disclosure is not limited to the embodiments disclosed below, and may be implemented in various different forms. In the following description, a case where a portion is connected to another portion includes a case where they are electrically connected to each other with another element interposed therebetween as well as a case in which they are directly connected to each other. In one or more embodiments of the present disclosure, a term "connection" between two configurations may mean that both of an electrical connection and a physical connection are inclusively used.

Hereinafter, a display device according to one or more embodiments of the present disclosure is described with reference to drawings related to embodiments of the present disclosure.

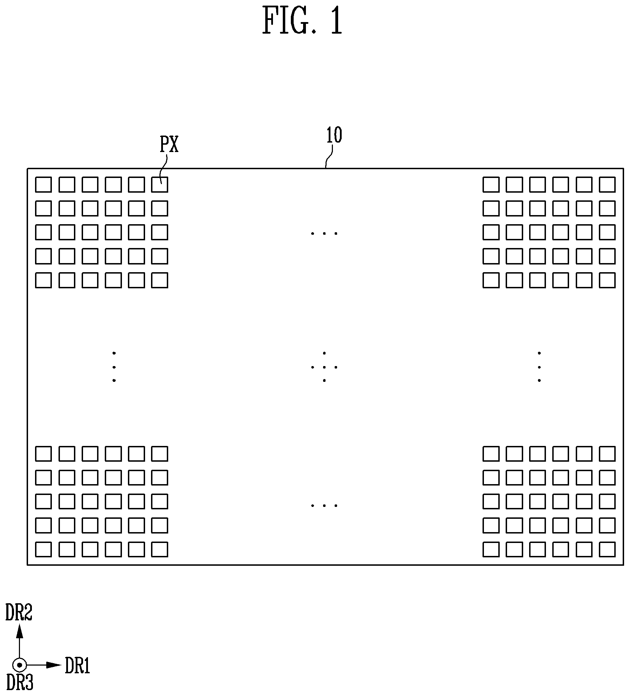

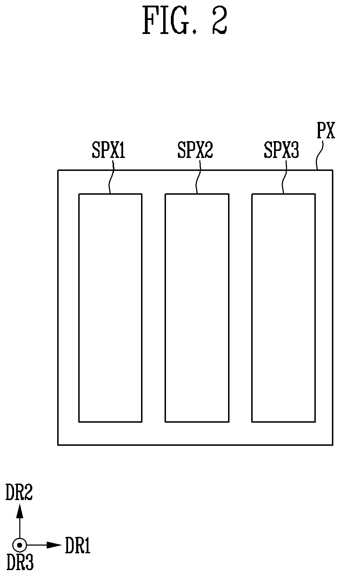

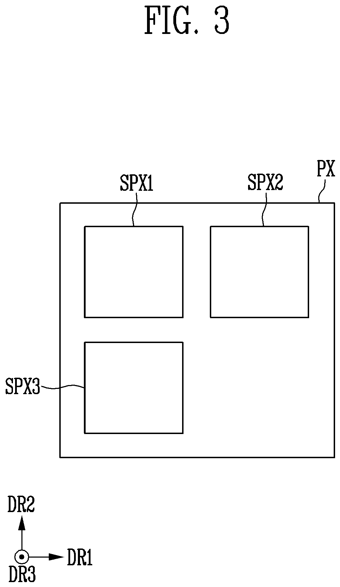

FIG. 1 is a plan view illustrating a display device according to one or more embodiments. FIG. 2 is a diagram illustrating an example of a pixel of FIG. 1. FIG. 3 is a diagram illustrating another example of the pixel of FIG. 1.

Referring to FIG. 1, the display device 10 (or a display panel) may be a device displaying an image, and may be used as a display screen of various products such as not only a portable electronic device such as a mobile phone, a smart phone, a tablet personal computer (PC), a smart watch, a watch phone, a mobile communication terminal, an electronic notebook, an electronic book, a portable multimedia player (PMP), a navigation device, and an ultra-mobile PC (UMPC), but also a television, a notebook computer, a monitor, a billboard, and Internet of things (IoT).

The display device 10 may have a rectangular shape in a plane and have a long side extending in a first direction DR1 and a short side extending in a second direction DR2 intersecting the first direction DR1. A corner where the long side extending in the first direction DR1 and the short side extending in the second direction DR2 meet may be formed round to have a suitable curvature (e.g., a predetermined curvature) or may be formed to have a right angle. A planar shape of the display device 10 is not limited to a quadrangle, and may be formed in another polygon, circle, or ellipse. The display device 10 may be formed to be flat, but is not limited thereto. The display device 10 (or the planar shape of the display device 10) may have an atypical shape. For example, the display device 10 may include a curved portion formed at left and right ends and having a constant curvature or a varying curvature. In addition, the display device 10 may be flexibly formed to be crooked, curved, bent, folded, and/or rolled.

The display device 10 may include pixels PX to display an image. The pixels PX may be arranged in a matrix form in the first direction DR1 and the second direction DR2, but are not limited thereto. For example, the pixels PX may be arranged along rows and columns of a matrix in the first direction DR1 and the second direction DR2. In addition, the display device 10 may further include gate lines (or scan lines) extending in the first direction DR1 and data lines extending in the second direction DR2.

Each of the pixels PX may include sub-pixels SPX1 to SPX3 as shown in FIGS. 2 and 3. FIGS. 2 and 3 illustrate that each of the pixels PX includes three sub-pixels SPX1 to SPX3, for example, a first sub-pixel SPX1, a second sub-pixel SPX2, and a third sub-pixel SPX3, but the present disclosure is not limited thereto.

Each of the first sub-pixel SPX1, the second sub-pixel SPX2, and the third sub-pixel SPX3 may be connected to any one of the data lines and at least one of the gate lines.

Each of the first sub-pixel SPX1, the second sub-pixel SPX2, and the third sub-pixel SPX3 may have a planar shape of a rectangle, a square, or a rhombus. For example, each of the first sub-pixel SPX1, the second sub-pixel SPX2, and the third sub-pixel SPX3 may have a planar shape of a rectangle having a short side of the first direction DR1 and a long side of the second direction DR2 as shown in FIG. 2. Alternatively, each of the first sub-pixel SPX1, the second sub-pixel SPX2, and the third sub-pixel SPX3 may have a planar shape of a square or a rhombus including sides having the same length in the first direction DR1 and the second direction DR2 as shown in FIG. 3.

As shown in FIG. 2, the first sub-pixel SPX1, the second sub-pixel SPX2, and the third sub-pixel SPX3 may be arranged along the first direction DR1. Alternatively, any one of the second sub-pixel SPX2 and the third sub-pixel SPX3 and the first sub-pixel SPX1 may be arranged along the first direction DR1, and the other one of the second sub-pixel SPX2 and the third sub-pixel SPX3 and the first sub-pixel SPX1 may be arranged along the second direction DR2. For example, as shown in FIG. 3, the first sub-pixel SPX1 and the second sub-pixel SPX2 may be arranged along the first direction DR1, and the first sub-pixel SPX1 and the third sub-pixel SPX3 may be arranged along the second direction DR2.

Alternatively, either the first sub-pixel SPX1 or the third sub-pixel SPX3, and the second sub-pixel SPX2 may be arranged along the first direction DR1, and the other one of the first sub-pixel SPX1 or the third sub-pixel SPX3, and the second sub-pixel SPX2 may be arranged along the second direction DR2. Alternatively, either the first sub-pixel SPX1 or the second sub-pixel SPX2, and the third sub-pixel SPX3 may be arranged along the first direction DR1, and the other one of the first sub-pixel SPX1 or the second sub-pixel SPX2, and the third sub-pixel SPX3 may be arranged along the second direction DR2.

The first sub-pixel SPX1 may emit a first color light, the second sub-pixel SPX2 may emit a second color light, and the third sub-pixel SPX3 may emit a third color light. Here, the first color light may be light of a red wavelength band, the second color light may be light of a green wavelength band, and the third color light may be light of a blue wavelength band. The red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the present disclosure is not limited thereto.

Each of the first sub-pixel SPX1, the second sub-pixel SPX2, and the third sub-pixel SPX3 may include an inorganic light emitting element including an inorganic semiconductor as a light emitting element that emits light. For example, the inorganic light emitting element may be a flip chip type of micro light emitting diode (LED), but the present disclosure is not limited thereto.

As shown in FIGS. 2 and 3, the area of the first sub-pixel SPX1, the area of the second sub-pixel SPX2, and the area of the third sub-pixel SPX3 may be substantially the same, but the present disclosure is not limited thereto. At least one of the area of the first sub-pixel SPX1, the area of the second sub-pixel SPX2, and/or the area of the third sub-pixel SPX3 may be different from another area. Alternatively, any two of the area of the first sub-pixel SPX1, the area of the second sub-pixel SPX2, and the area of the third sub-pixel SPX3 may be substantially the same and the other one may be different from the two areas. Alternatively, the area of the first sub-pixel SPX1, the area of the second sub-pixel SPX2, and the area of the third sub-pixel SPX3 may be different from each other.

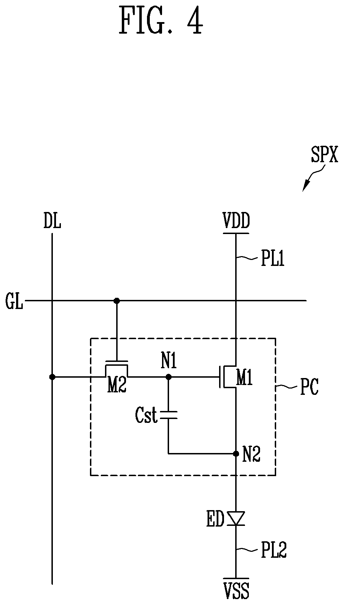

FIG. 4 is a circuit diagram illustrating an example of a sub-pixel included in the pixel of FIGS. 2 and 3. The sub-pixel SPX shown in FIG. 4 may be any one of the sub-pixels SPX1 to SPX3 included in the pixel PX of FIGS. 2 and 3. The sub-pixels SPX1 to SPX3 may have structures (or circuits) substantially identical to or similar to each other.

Referring to FIG. 4, the sub-pixel SPX may be connected to a gate line GL, a data line DL, a first power line PL1, and a second power line PL2. In addition, the sub-pixel SPX may be further connected to at least another power line and/or signal line.

A gate signal (or a scan signal) may be supplied to the gate line GL, a data signal may be supplied to the data line DL, a voltage of first power VDD may be applied to the first power line PL1, and a voltage of second power VSS may be applied to the second power line PL2. The first power VDD and the second power VSS may have different potentials.

The sub-pixel SPX may include a light emitting element ED for generating light of a luminance corresponding to each data signal. In addition, the sub-pixel SPX may further include a pixel circuit PC for driving the light emitting element ED.

The pixel circuit PC may be electrically connected to the gate line GL and the data line DL, and may be electrically connected between the first power line PL1 and the light emitting element ED.

The pixel circuit PC may include at least one transistor and a capacitor Cst. For example, the pixel circuit PC may include a first transistor M1, a second transistor M2, and the capacitor Cst.

The first transistor M1 may be connected between the first power line PL1 and a second node N2. The second node N2 may be a node to which the pixel circuit PC and the light emitting element ED are connected. For example, the second node N2 may be a node where one electrode (for example, a source electrode) of the first transistor M1 and the light emitting element ED are electrically connected to each other. A gate electrode of the first transistor M1 may be connected to a first node N1. The first transistor M1 may control a driving current supplied to the light emitting element ED in response to a voltage of the first node N1. For example, the first transistor M1 may be a driving transistor of the sub-pixel SPX.

The second transistor M2 may be connected between the data line DL and the first node N1. In addition, a gate electrode of the second transistor M2 may be connected to the gate line GL. The second transistor M2 may be turned on when a gate signal of a gate-on voltage (for example, a logic high voltage or a high level voltage) is supplied from the gate line GL, to connect the data line DL and the first node N1.

A data signal of a corresponding frame may be supplied to the data line DL for each frame period, and the data signal may be transferred to the first node N1 through the second transistor M2 during a period in which the gate signal of the gate-on voltage is supplied. For example, the second transistor M2 may be a switching transistor for transferring each data signal to an inside of the sub-pixel SPX.

A first electrode of the capacitor Cst may be connected to the first node N1, and a second electrode of the capacitor Cst may be connected to the second node N2. The capacitor Cst may be charged with a voltage corresponding to the data signal supplied to the first node N1 during each frame period.

In FIG. 4, both of the first and second transistors M1 and M2 included in the pixel circuit PC are n-type transistors, but the present disclosure is not limited thereto. For example, at least one of the first and second transistors M1 and M2 may be changed to a p-type transistor. A structure and a driving method of the sub-pixel SPX may be variously changed according to one or more embodiments.

In addition, the pixel circuit PC may further include other circuit elements such as an initialization transistor (or a sensing transistor) for initializing an anode electrode of the light emitting element ED, a compensation transistor for compensating for a threshold voltage or the like of the first transistor M1, an initialization transistor for initializing the voltage of the first node N1, an emission control transistor for controlling a period in which the driving current is supplied to the light emitting element ED, and/or a boosting capacitor for boosting the voltage of the first node N1.

The light emitting element ED may emit light with a luminance corresponding to the driving current supplied through the pixel circuit PC. The light emitting element ED may be connected between the first transistor M1 and the second power line PL2. A first electrode of the light emitting element ED may be connected to one electrode (or the second node N2) of the first transistor M1, and a second electrode of the light emitting element ED may be connected to the second power line PL2. Here, the first electrode of the light emitting element ED may be an anode electrode, and the second electrode of the light emitting element ED may be a cathode electrode. The light emitting element ED may be an inorganic light emitting element including the first electrode, the second electrode, and an inorganic semiconductor disposed between the first electrode and the second electrode. For example, the light emitting element ED may be a micro light emitting diode (LED) formed of an inorganic semiconductor, but is not limited thereto.

In FIG. 4, the sub-pixel SPX includes only one light emitting element ED, but the present disclosure is not limited thereto. For example, the sub-pixel SPX may further include at least one light emitting element connected to the light emitting element ED in parallel. As another example, the sub-pixel SPX may further include at least one light emitting element connected to the light emitting element ED in series. The number, type, and/or structure of the light emitting elements ED configuring an effective light source of the sub-pixel SPX may be changed according to one or more embodiments.

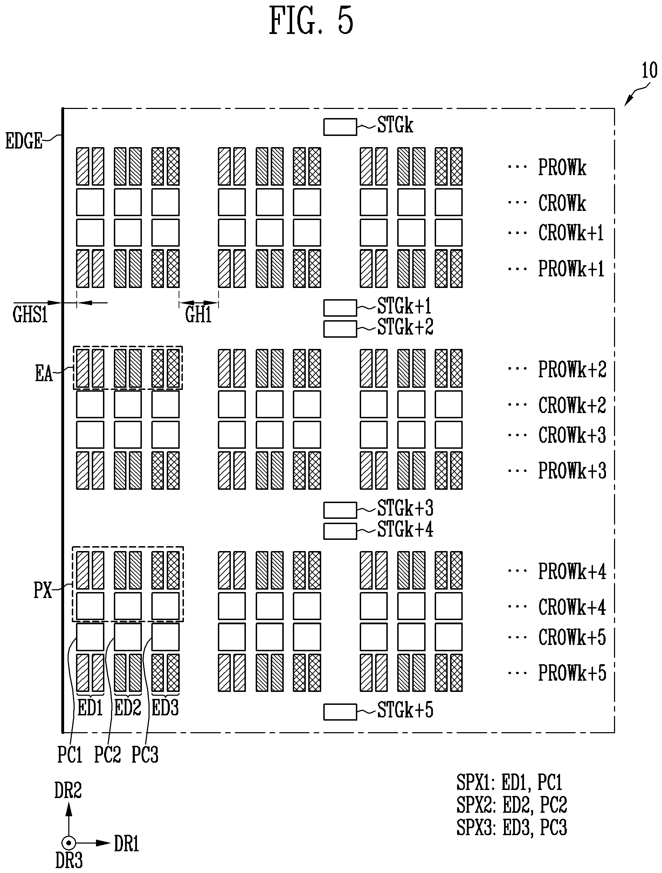

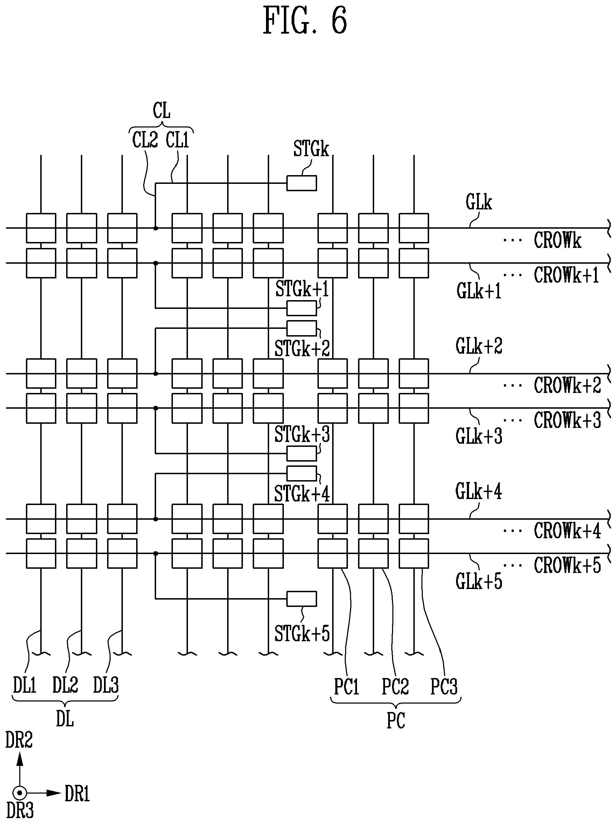

FIG. 5 is a plan view illustrating an embodiment of the display device of FIG. 1. FIG. 6 is a diagram illustrating a connection relationship between a pixel circuit and a stage included in the display device of FIG. 5. A plurality of stages may configure at least one gate driver (or scan driver).

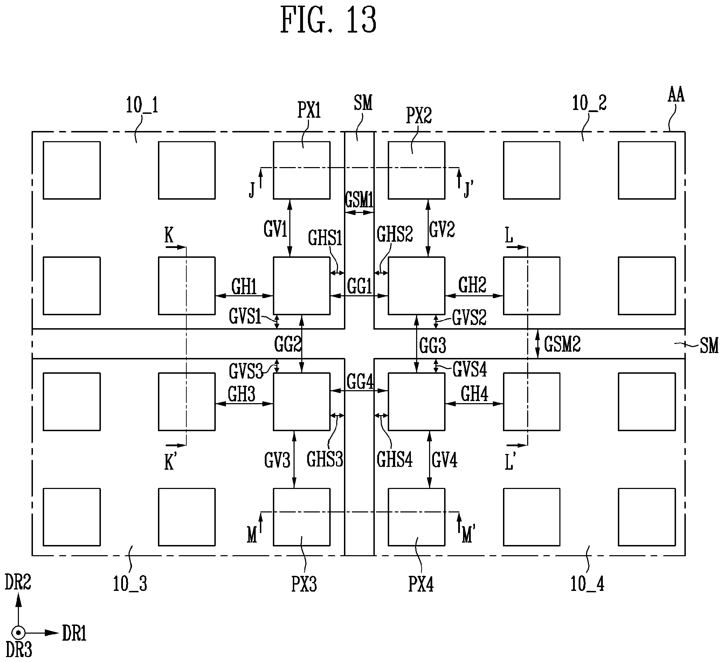

Referring to FIGS. 1 to 6, the display device 10 may include the pixels PX. The pixels PX may be spaced from each other by a first horizontal separation distance GH1 (or a first separation distance). For example, based on an emission area EA, the pixels PX may be spaced in the first direction DR1 by the first horizontal distance GH1. In one or more embodiments, the pixel PX (that is, the outermost pixel) positioned at the outermost portion of the display device 10 may be spaced from an edge EDGE of the display device 10 (or a substrate) by a distance within a minimum distance GHS1 (or a second separation distance). The minimum distance GHS1 may be less than the first horizontal separation distance GH1. For example, the minimum distance GHS1 may be less than half of the first horizontal separation distance GH1. That is, the display device 10 may have a negative dead space (that is, a dead space less than a pixel distance). The minimum distance GHS1 and the first horizontal separation distance GH1 are described later with reference to FIG. 13.

The pixel PX may include the first to third sub-pixels SPX1 to SPX3.

The first sub-pixel SPX1 may include a first light emitting element ED1 and a first pixel circuit PC1, and the first pixel circuit PC1 may supply a driving current to the first light emitting element ED1. The first pixel circuit PC1 may be positioned in the second direction DR2 with respect to the first light emitting element ED1, and the first pixel circuit PC1 may be electrically connected to the first light emitting element ED1. The second sub-pixel SPX2 may include a second light emitting element ED2 and a second pixel circuit PC2, and the second pixel circuit PC2 may supply a driving current to the second light emitting element ED2. The second pixel circuit PC2 may be positioned in the second direction DR2 with respect to the second light emitting element ED2, and the second pixel circuit PC2 may be electrically connected to the second light emitting element ED2. The third sub-pixel SPX3 may include a third light emitting element ED3 and a third pixel circuit PC3, and the third pixel circuit PC3 may supply a driving current to the third light emitting element ED3. The third pixel circuit PC3 may be positioned in the second direction DR2 with respect to the third light emitting element ED3, and the third pixel circuit PC3 may be electrically connected to the third light emitting element ED3.

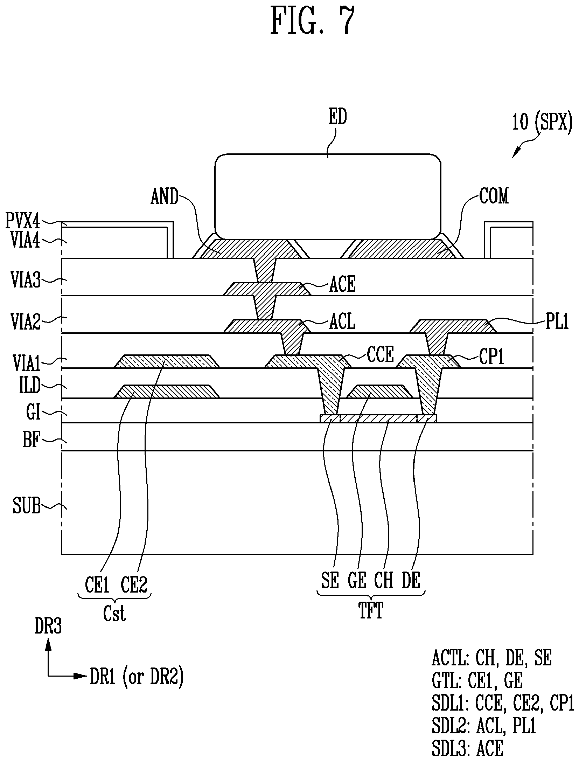

According to one or more embodiments, each of the first to third sub-pixels SPX1 to SPX3 may include two light emitting elements. For example, each of the first to third sub-pixels SPX1 to SPX3 may include a main light emitting element and a repair light emitting element, but is not limited thereto. As another example, each of the first to third sub-pixels SPX1 to SPX3 may include three or more light emitting elements. Although described later with reference to FIG. 7, the first to third light emitting elements ED1 to ED3 shown in FIG. 5 may refer to electrodes (for example, an anode electrode and a cathode electrode) of each of the first to third light emitting elements ED1 to ED3.

Based on the light emitting elements ED1 to ED3, the pixels PX may be arranged to have a uniform pixel pitch. The light emitting elements ED1 to ED3 may be arranged along a plurality of pixel rows. For example, the light emitting elements ED1 to ED3 may be arranged along k-th to (k+5)-th pixel rows PROWk to PROWk+5 (where k is a positive integer). The pixel circuits PC1 to PC3 may be arranged along a plurality of circuit rows. The pixel circuits PC1 to PC3 may be arranged along k-th to (k+5)-th circuit rows CROWk to CROWk+5.

The k-th pixel row PROWk may be adjacent to the k-th circuit row CROWk in a direction opposite to the second direction DR2, and the (k+1)-th pixel row PROWk+1 may be adjacent to the (k+1)-th circuit row CROWk+1 in the second direction DR2. The k-th and (k+1)-th circuit rows CROWk and CROWk+1 may be disposed between the k-th and (k+1)-th pixel rows PROWk and PROWk+1. Similarly, the (k+2)-th pixel row PROWk+2 may be adjacent to the (k+2)-th circuit row CROWk+2 in the direction opposite to the second direction DR2, and the (k+3)-th pixel row PROWk+3 may be adjacent to the (k+3)-th circuit row CROWk+3 in the second direction DR2. The (k+2)-th and (k+3)-th circuit rows CROWk+2 and CROWk+3 may be disposed between the (k+2)-th and (k+3)-th pixel rows PROWk+2 and PROWk+3. Similarly, the (k+4)-th pixel row PROWk+4 may be adjacent to the (k+4)-th circuit row CROWk+4 in the direction opposite to the second direction DR2, and the (k+5)-th pixel row PROWk+5 may be adjacent to the (k+5)-th circuit row CROWk+5 in the second direction DR2. The (k+4)-th and (k+5)-th circuit rows CROWk+4 and CROWk+5 may be disposed between the (k+4)-th and (k+5)-th pixel rows PROWk+4 and PROWk+5.

A k-th stage STGk may be disposed on an upper side of the k-th circuit row CROWk and the k-th pixel row PROWk. The k-th stage STGk may supply a gate signal to a k-th gate line GLk connected to the pixel circuits PC1, PC2, and PC3 of the k-th circuit row CROWk. The k-th stage STGk may be connected to the k-th gate line GLk through a connection line CL. For example, the k-th stage STGk may be connected to the k-th gate line GLk through a first connection line CL1 extending in the first direction DR1 and a second connection line CL2 extending in the second direction DR2.

A (k+1)-th stage STGk+1 and a (k+2)-th stage STGk+2 may be disposed between the (k+1)-th pixel row PROWk+1 and the (k+2)-th pixel row PROWk+2. The (k+1)-th stage STGk+1 may be disposed on a lower side of the (k+1)-th circuit row CROWk+1 and the (k+1)-th pixel row PROWk+1. The (k+1)-th stage STGk+1 may supply a gate signal to a (k+1)-th gate line GLk+1 connected to the pixel circuits PC of the (k+1)-th circuit row CROWk+1. The (k+1)-th stage STGk+1 may be connected to the (k+1)-th gate line GLk+1 through the connection line CL.

A (k+2)-th stage STGk+2 may be disposed on an upper side of the (k+2)-th circuit row CROWk+2 and the (k+2)-th pixel row PROWk+2. The (k+2)-th stage STGk+2 may supply a gate signal to the (k+2)-th gate line GLk+2 connected to the pixel circuits PC of the (k+2)-th circuit row CROWk+2. The (k+2)-th stage STGk+2 may be connected to the (k+2)-th gate line GLk+2 through the connection line CL.

A (k+3)-th stage STGk+3 and a (k+4)-th stage STGk+4 may be disposed between the (k+3)-th pixel row PROWk+3 and the (k+4)-th pixel row PROWk+4. The (k+3)-th stage STGk+3 may be disposed on a lower side of the (k+3)-th circuit row CROWk+3 and the (k+3)-th pixel row PROWk+3. The (k+3)-th stage STGk+3 may supply a gate signal to a (k+3)-th gate line GLk+3 connected to the pixel circuits PC of the (k+3)-th circuit row CROWk+3. The (k+3)-th stage STGk+3 may be connected to the (k+3)-th gate line GLk+3 through the connection line CL.

The (k+4)-th stage STGk+4 may be disposed on an upper side of the (k+4)-th circuit row CROWk+4 and the (k+4)-th pixel row PROWk+4. The (k+4)-th stage STGk+4 may supply a gate signal to a (k+4)-th gate line GLk+4 connected to the pixel circuits PC of the (k+4)-th circuit row CROWk+4. The (k+4)-th stage STGk+4 may be connected to the (k+4)-th gate line GLk+4 through the connection line CL.

A (k+5)-th stage STGk+5 may be disposed on a lower side of the (k+5)-th circuit row CROWk+5 and the (k+5)-th pixel row PROWk+5. The (k+5)-th stage STGk+5 may supply a gate signal to a (k+5)-th gate line GLk+5 connected to the pixel circuits PC of the (k+5)-th circuit row CROWk+5. The (k+5)-th stage STGk+5 may be connected to the (k+5)-th gate line GLk+5 through the connection line CL.

The data line DL may include first to third data lines DL1 to DL3. The first data line DL1 may supply a data voltage to a plurality of first pixel circuits PC1 disposed in the same column. The second data line DL2 may supply a data voltage to a plurality of second pixel circuits PC2 disposed in the same column. The third data line DL3 may supply a data voltage to a plurality of third pixel circuits PC3 disposed in the same column.

FIG. 7 is a cross-sectional view illustrating an embodiment of the display device of FIG. 1. In FIG. 7, a cross-section of the display device 10 is briefly shown based on the sub-pixel SPX.

Referring to FIGS. 1 to 7, the sub-pixel SPX (of the display device 10, or the display panel) may include a substrate SUB (or a base layer), a buffer layer BF, an active layer ACTL, a gate insulating layer GI, a gate layer GTL, an interlayer insulating layer ILD, a first source metal layer SDL1, a first via layer VIA1, a second source metal layer SDL2, a second via layer VIA2, a third source metal layer SDL3, a third via layer VIA3, a pixel electrode layer, a fourth via layer VIA4, and a fourth protective layer PVX4 (or a protective layer).

The substrate SUB may be a base substrate or a base member for supporting the display device 10. The substrate SUB may be a flexible substrate of which bending, folding, rolling, and/or the like is possible. In this case, the substrate SUB may include an insulating material such as a polymer resin such as polyimide (PI). The substrate SUB may have a single-layer structure or a multi-layer structure.

The buffer layer BF may be disposed on one surface of the substrate SUB. The buffer layer BF may prevent penetration of air or moisture. The buffer layer BF may be an insulating layer including an inorganic material. For example, the inorganic material may include at least one of metal oxides such as silicon nitride (SiNₓ), silicon oxide (SiOₓ), silicon oxynitride (SiOₓN_{y}), and/or aluminium oxide (AlOₓ). The buffer layer BF may be omitted according to a material, a process condition, or the like of the substrate SUB.

The active layer ACTL may be disposed on the buffer layer BF. The active layer ACTL may include a silicon semiconductor such as polycrystalline silicon, single crystal silicon, low-temperature polycrystalline silicon, and/or amorphous silicon, or may include an oxide semiconductor.

The active layer ACTL may include a channel CH, a first electrode SE, and a second electrode DE of a transistor TFT. Here, the transistor TFT may be a transistor included in the pixel circuit PC of FIG. 4, and for example, the transistor TFT may be the first transistor M1. The channel CH of the transistor TFT may be an area overlapping a gate electrode GE of the transistor TFT in a third direction DR3, which is a thickness direction of the substrate SUB. The first electrode SE of the transistor TFT may be disposed on one side of the channel CH, and the second electrode DE may be disposed on another side of the channel CH. The first electrode SE and the second electrode DE of the transistor TFT may be areas that do not overlap the gate electrode GE in the third direction DR3. The channel CH of the transistor TFT may be a semiconductor pattern that is not doped with an impurity and may be an intrinsic semiconductor. The first electrode SE and the second electrode DE of the transistor TFT may be semiconductor patterns that are doped with an impurity.

The gate insulating layer GI may be disposed on the active layer ACTL. The gate insulating layer GI may be an insulating layer including an inorganic material.

The gate layer GTL may be disposed on the gate insulating layer GI. The gate layer GTL may include a conductive material. For example, the conductive material may include copper (Cu), molybdenum (Mo), tungsten (W), aluminium neodymium (AlNd), titanium (Ti), aluminium (Al), silver (Ag), and/or an alloy thereof. The gate layer GTL may be formed as a single layer or multiple layers.

The gate layer GTL may include the gate electrode GE of the transistor TFT and a first capacitor electrode CE1.

The interlayer insulating layer ILD may be disposed on the gate layer GTL. The interlayer insulating layer ILD may be an insulating layer including an inorganic material.

The first source metal layer SDL1 (or a first conductive pattern) may be disposed on the interlayer insulating layer ILD. The first source metal layer SDL1 may include a conductive material and may be formed as a single layer or multiple layers.

The first source metal layer SDL1 may include a connection electrode CCE, a second capacitor electrode CE2, and a first connection pattern CP1 (or a bridge pattern). The connection electrode CCE may be connected to the first electrode SE (or the second electrode DE) of the transistor TFT through a contact hole passing through the interlayer insulating layer ILD and the gate insulating layer GI. The second capacitor electrode CE2 may configure the capacitor Cst (refer to FIG. 4) with the first capacitor electrode CE1 by overlapping the first capacitor electrode CE1 in the third direction DR3 with the interlayer insulating layer ILD therebetween. The first connection pattern CP1 may be connected to the second electrode DE (or the first electrode SE) of the transistor TFT through a contact hole passing through the interlayer insulating layer ILD and the gate insulating layer GI.

The first via layer VIA1 (e.g., a first planarization layer, or a first organic layer) may be disposed on the first source metal layer SDL1. The first via layer VIA1 may flatten a step difference due to the active layer ACTL, the gate layer GTL, and the first source metal layer SDL1. The first via layer VIA1 may be an insulating layer including an organic material. For example, the organic material may include acrylic resin, epoxy resin, phenolic resin, polyamide resin, polyimide resin, and/or the like.

The second source metal layer SDL2 (or a second conductive pattern) may be disposed on the first via layer VIA1. The second source metal layer SDL2 may include a conductive material and may be formed as a single layer or multiple layers.

The second source metal layer SDL2 may include an anode connection line ACL and the first power line PL1. The anode connection line ACL may be connected to the connection electrode CCE through a contact hole passing through the first via layer VIA1. The first power line PL1 may be connected to the first connection pattern CP1 through a contact hole passing through the first via layer VIA1.

According to one or more embodiments, the second source metal layer SDL2 may further include other lines. For example, the other lines may include the data line DL, the second power line PL2, or may be electrically connected to the data line DL, the second power line PL2, and/or the like.

According to one or more embodiments, the first via layer VIA1 may be omitted. In this case, the connection electrode CCE may be included in the anode connection line ACL or may be omitted. For example, the anode connection line ACL may be connected to the first electrode SE of the transistor TFT through a contact hole passing through the interlayer insulating layer ILD and the gate insulating layer GI.

The second via layer VIA2 or (a second organic layer) may be disposed on the second source metal layer SDL2. The second via layer VIA2 may be an insulating layer including an organic material. The second via layer VIA2 may include the same material as the first via layer VIA1.

The third source metal layer SDL3 or (a third conductive pattern) may be disposed on the second via layer VIA2. The third source metal layer SDL3 may include a conductive material and may be formed as a single layer or multiple layers.

The third source metal layer SDL3 may include an anode connection electrode ACE (or a bridge electrode). The anode connection electrode ACE may be connected to the anode connection line ACL through a contact hole passing through the second via layer VIA2.

The third via layer VIA3 (or a third organic layer) may be disposed on the third source metal layer SDL3. The third via layer VIA3 may be an insulating layer including an organic material. The third via layer VIA3 may include the same material as the first via layer VIA1 and/or the second via layer VIA2.

The pixel electrode layer may be disposed on the third via layer VIA3. The pixel electrode layer may include a pixel electrode AND (or a first pixel electrode) and a common electrode COM (or a second pixel electrode). The pixel electrode AND may be referred to as an anode electrode, and the common electrode COM may be referred to as a cathode electrode.

The pixel electrode AND may be connected to the anode connection electrode ACE through a contact hole passing through the third via layer VIA3. Through this, the pixel electrode AND may be electrically connected to the first electrode SE of the transistor TFT. Accordingly, a pixel voltage (or a driving current) controlled by the transistor TFT may be applied to the pixel electrode AND.

Similar to the pixel electrode AND, the common electrode COM may be electrically connected to a power line (for example, the second power line PL2) through a contact hole passing through the third via layer VIA3 (and the second via layer VIA2). Through this, a power voltage of a power line may be applied to the common electrode COM.

The pixel electrode AND and the common electrode COM may include a metal material having high reflectance such as a stack structure of aluminium and titanium (Ti/Al/Ti), a stack structure of aluminium and ITO (ITO/Al/ITO), an APC alloy, or a stack structure of an APC alloy and/or ITO (ITO/APC/ITO). The APC alloy is an alloy of silver (Ag), palladium (Pd), and/or copper (Cu).

The fourth via layer VIA4 (e.g., a fourth organic layer, a bank, or a pixel definition layer) may be disposed on the third via layer VIA3. The fourth via layer VIA4 may be an insulating layer including an organic material. The fourth via layer VIA4 may include an opening, and at least a portion of the pixel electrode AND and the common electrode COM may be exposed through the opening.

The fourth protective layer PVX4 (or an inorganic layer) may be disposed on the fourth via layer VIA4. The fourth protective layer PVX4 may partially cover the pixel electrode AND and the common electrode COM. For example, the fourth protective layer PVX4 may cover an edge of the pixel electrode AND and an edge of the common electrode COM. The fourth protective layer PVX4 may be an insulating layer including an inorganic material.

In one or more embodiments, a protective layer or an inorganic layer (or an insulating layer or an inorganic layer including an inorganic material) may not be disposed between the first to fourth via layers VIA1 to VIA4. For example, an inorganic layer may not be disposed between the first via layer VIA1 and the second via layer VIA2, and the second via layer VIA2 may be disposed directly on the first via layer VIA1 and may contact the first via layer VIA1. When an inorganic layer is disposed between the first via layer VIA1 and the second via layer VIA2, a defect may occur in adhesion between the first via layer VIA1 and the second via layer VIA2. For example, a phenomenon in which the second via layer VIA2 is lifted from the first via layer VIA1 may occur. In other words, when an inorganic layer is not disposed between the first via layer VIA1 and the second via layer VIA2, the first via layer VIA1 and the second via layer VIA2 may be stably attached to each other. In addition, because a process (and a mask) for forming the inorganic layer is excluded, a manufacturing cost of the display device 10 may be reduced. Similarly, an inorganic layer may not be disposed between the second via layer VIA2 and the third via layer VIA3 and between the third via layer VIA3 and the fourth via layer VIA4. That is, the third via layer VIA3 may be disposed directly on the second via layer VIA2, and the fourth via layer VIA4 may be disposed directly on the third via layer VIA3.

The light emitting element ED may be disposed in the opening of the fourth via layer VIA4 (and the fourth protective layer PVX4). The light emitting element ED may be disposed on the pixel electrode AND and the common electrode COM which are not covered by the fourth protective layer PVX4 (or exposed by the fourth protective layer PVX4).

For example, the light emitting element ED may be a flip chip type of micro LED. The light emitting element ED may be formed of an inorganic material such as GaN. Each of the lengths in the first direction DR1, the second direction DR2, and the third direction DR3 of the light emitting element ED may be several to hundreds of µm. For example, each of the lengths in the first direction DR1, the second direction DR2, and the third direction DR3 of the light emitting element ED may be about 100 µm or less.

In FIG. 7, the first power line PL1 and other lines (for example, the data line DL) are disposed in the second metal layer SDL2, but the present disclosure is not limited thereto. For example, lines including the first power line PL1 may be disposed in at least one of the gate layer GTL, the first source metal layer SDL1, and/or the third source metal layer SDL3.

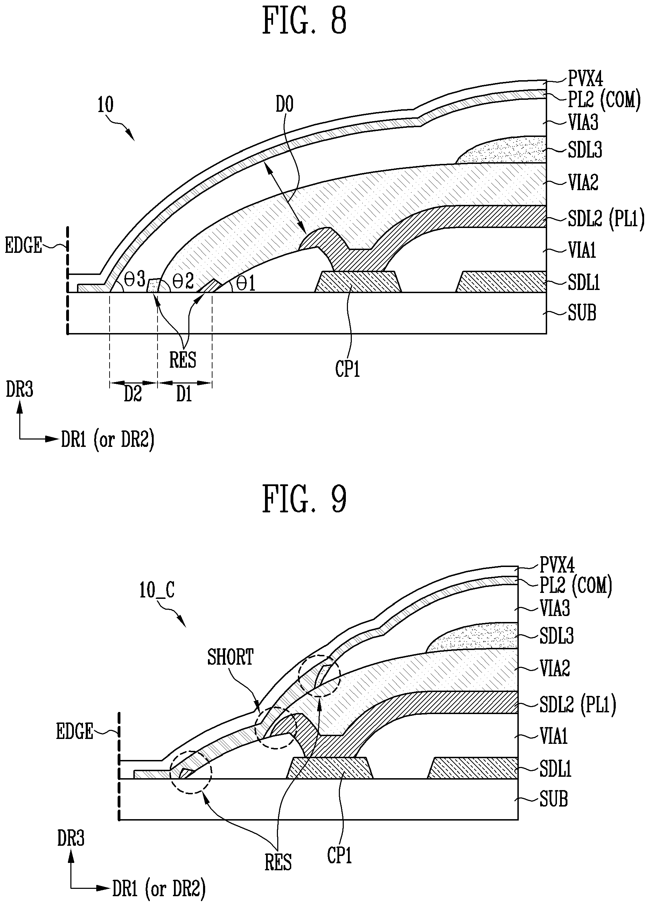

FIG. 8 is a cross-sectional view illustrating an embodiment of the display device of FIG. 1. In FIG. 8, a cross-section of an outer portion of the display device 10 adjacent to the edge EDGE is briefly shown based on the first to third via layers VIA1 to VIA3. The edge EDGE may be one of one side of the display device 10 of FIG. 1, for example, a left side, a lower side, or a right side.

Referring to FIGS. 7 and 8, because the substrate SUB and the first source metal layer SDL1 to the fourth protective layer PVX4 are described with reference to FIG. 7, an overlapping description is not repeated. In FIG. 8, a configuration (for example, the transistor TFT, the interlayer insulating layer ILD, and the like) between the substrate SUB and the first source metal layer SDL1 of FIG. 7 is omitted, but it should be understood that the embodiment of FIG. 8 includes the configuration of FIG. 7.

In one or more embodiments, the first to third via layers VIA1 to VIA3 may have a clad structure. That is, the third via layer VIA3 or the second via layer VIA2 may clad or cover a lower configuration (for example, the first via layer VIA1).

For example, as shown in FIG. 8, in the outer portion of the display device 10, the second via layer VIA2 may cover the first via layer VIA1, and the second via layer VIA2 may be in contact with the substrate SUB (or a configuration under the first via layer VIA1). The second via layer VIA2 may cover the first via layer VIA1 over the entire display device 10.

For reference, in a process of forming (for example, patterning) the second source metal layer SDL2 (for example, the first power line PL1) on the first via layer VIA1, near an edge of the first via layer VIA1 (that is, near a point where a slope of the substrate SUB starts relative to a reference), a portion of the second source metal layer SDL2 may not be properly etched or removed, and the portion of the second source metal layer SDL2 may occur or exist as a residue RES. The residue RES may cause a defect (for example, a short circuit). The second via layer VIA2 may cover the residue RES of the second source metal layer SDL2 and may prevent the defect caused by the residue RES.

In one or more embodiments, in a plan view, the second via layer VIA2 may be extended by a length equal to or greater than an average thickness (for example, a thickness of the third direction DR3) of the first via layer VIA1 (or the second via layer VIA2) than the first via layer VIA1 toward the edge EDGE of the substrate SUB. For example, the average thickness of the third direction DR3 of the first via layer VIA1 (or each of the first to third via layers VIA1 to VIA3) may be about 5 µm, and a distance D1 by which the second via layer VIA2 protrudes beyond the first via layer VIA1 in a direction opposite to the first direction DR1 may be equal to or greater than about 5 µm. In this case, the residue RES and an upper structure (that is, a structure on the second via layer VIA2) may be electrically spaced sufficiently, and thus a defect caused by the residue RES may be prevented. As the distance D1 increases, the defect caused by the residue RES may be more securely prevented. However, the distance D1 may be limited in consideration of the minimum distance GHS1 described with reference to FIG. 5. For example, when the minimum distance GHS1 is about 20 µm to about 30 µm, the distance D1 may be about 9 µm to about 10 µm.

In one or more embodiments, an edge portion of the second via layer VIA2 may be in contact with a first surface of the substrate SUB (or the base layer), and an angle formed by the edge portion of the second via layer VIA2 and the first surface of the substrate SUB may be equal to or less than about 47 degrees. That is, a taper angle θ2 of the second via layer VIA2 may be equal to or less than about 47 degrees. In this case, an opening may not occur in the third source metal layer SDL3 on the second via layer VIA2 (particularly, a slope surface of the second via layer VIA2). In addition, as the taper angle θ2 of the second via layer VIA2 decreases, the residue RES may not occur. In consideration of the minimum distance GHS1 of FIG. 5, the taper angle θ2 of the second via layer VIA2 may be about 35 degrees to about 45 degrees. A taper angle θ1 of the first via layer VIA1 may be equal or similar to the taper angle θ2 of the second via layer VIA2, but is not limited thereto.

Similar to the second via layer VIA2, the third via layer VIA3 may cover the second via layer VIA2, and the third via layer VIA3 may be in contact with the substrate SUB (or a configuration under the first via layer VIA1). The third via layer VIA3 may cover the second via layer VIA2 over the entire display device 10. The third via layer VIA3 may cover the residue RES of the third source metal layer SDL3 and may prevent the defect caused by the residue RES.

In one or more embodiments, in a plan view, the third via layer VIA3 may be extended by a length equal to or greater than an average thickness of the third via layer VIA3 than the second via layer VIA2 toward the edge EDGE of the substrate SUB. For example, a distance D2 by which the third via layer VIA3 protrudes beyond the second via layer VIA2 in the direction opposite to the first direction DR1 may be equal to or greater than 5 µm. For example, the distance D2 considering the minimum distance GHS1 (refer to FIG. 5) may be about 9 µm to about 10 µm.

In one or more embodiments, an edge portion of the third via layer VIA3 may be in contact with the first surface of the substrate SUB (or the base layer), and an angle formed by the edge portion of the third via layer VIA3 and the first surface of the substrate SUB may be equal to or less than about 47 degrees. That is, a taper angle θ3 of the third via layer VIA3 may be equal to or less than about 47 degrees. The taper angle θ3 of the third via layer VIA3 may be about 35 degrees to about 45 degrees in consideration of the minimum distance GHS1 of FIG. 5.

The second power line PL2 (or a common electrode COM) may be disposed on the third via layer VIA3. The second power line PL2 (or the common electrode COM) may be disposed entirely on the substrate SUB to reduce a resistance. In this case, in the outer portion of the display device 10, the second power line PL2 (or the common electrode COM) may overlap the second source metal layer SDL2 (or the first power line PL1). The second source metal layer SDL2 and the second power line PL2 (or the common electrode COM) may be spaced by a distance D0 that is equal to or greater than the average thickness of the second via layer VIA2 or the third via layer VIA3. Therefore, a short circuit may not occur between the second source metal layer SDL2 and the second power line PL2 (or the common electrode COM). Similarly, the residue RES of the second source metal layer SDL2 may also be spaced from the second power line PL2 (or the common electrode COM) by the distance D0 that is equal to or greater than the average thickness of the second via layer VIA2 or the third via layer VIA3.

The third source metal layer SDL3 and the second power line PL2 (or the common electrode COM) may be spaced by the average thickness of the third via layer VIA3. Therefore, a short circuit may not occur between the third source metal layer SDL3 and the second power line PL2 (or the common electrode COM). Similarly, the residue RES of the third source metal layer SDL3 may also be spaced from the second power line PL2 (or the common electrode COM) by the average thickness of the third via layer VIA3.

The fourth protective layer PVX4 may cover the second power line PL2 (or the common electrode COM).

In one or more embodiments, another organic structure (or an organic layer, for example, a dam) may not be disposed between the third via layer VIA3 and the edge EDGE in the first direction DR1. When another organic structure is disposed, the minimum distance GHS1 (refer to FIG. 5) may not be secured.

As described above, a protective layer (or an inorganic layer) may not exist between the first to third via layers VIA1 to VIA3, which are organic layers. Therefore, a defect may not occur in adhesion between the first to third via layers VIA1 to VIA3. In addition, the first to third via layers VIA1 to VIA3 may have a clad structure. The second via layer VIA2 may cover the first via layer VIA1 and the second source metal layer SDL2 (and the residue RES), and the third via layer VIA3 may cover the second via layer VIA2 and the third source metal layer SDL3 (and the residue RES). Therefore, the defect (for example, a short circuit) caused by the second and third source metal layers SDL2 and SDL3 (and the residue RES) may be prevented. The taper angles θ2 and θ3 of the second via layer VIA2 and the third via layer VIA3 may be equal to or less than about 47 degrees, and the occurrence of the residue RES may be reduced. The second via layer VIA2 and the third via layer VIA3 may cover an underlying configuration or structure by about 9 µm to about 10 µm, and may more securely prevent the defect caused by the residue RES.

FIG. 9 is a cross-sectional view illustrating a comparative example of the display device of FIG. 1. In FIG. 9, a cross-section of an outer portion of the display device 10_C adjacent to the edge EDGE is briefly shown, in correspondence with the display device 10 of FIG. 8.

Referring to FIGS. 8 and 9, except for a disposition of the second and third via layers VIA2 and VIA3, the display device 10_C according to the comparative example of FIG. 9 is similar to the display device 10 of FIG. 8, and thus an overlapping description may not be repeated.

In the display device 10_C, the first to third via layers VIA1 to VIA3 may have a step structure rather than a clad structure.

As shown in FIG. 9, in the outer portion of the display device 10_C, the second via layer VIA2 may not cover (e.g., may not completely cover) the first via layer VIA1, and the first via layer VIA1 may be exposed by the second via layer VIA2. In this case, the residue RES of the second source metal layer SDL2 may be exposed, may contact the second power line PL2, and may cause a short circuit defect.

Similarly, the third via layer VIA3 may not cover (e.g., may not completely cover) the second via layer VIA2, and the second via layer VIA2 may be exposed by the third via layer VIA3. In this case, the residue RES of the third source metal layer SDL3 may be exposed, may contact the second power line PL2, and may cause a short circuit defect.

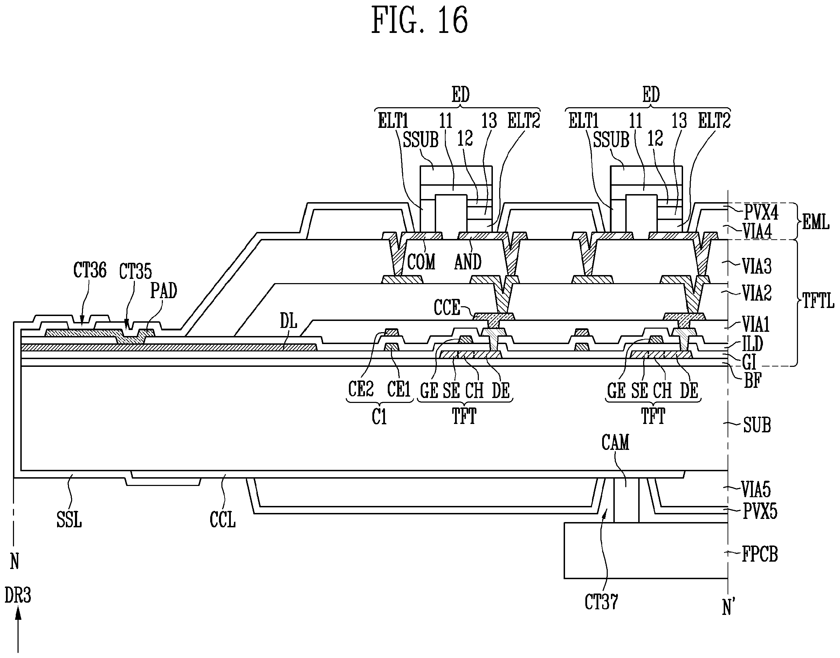

As will be described later with reference to FIG. 16, the display device 10_C may include a conductive pattern disposed on a rear surface in addition to a front surface. In order to form the conductive pattern on the rear surface of the display device 10_C, a rear surface process may be performed in addition to a front surface process. For example, the front surface process may be performed in a state in which a front surface of the display device 10_C faces upward, and the rear surface process may be performed in a state in which the display device 10_C is turned over so that a rear surface of the display device 10_C faces upward. For example, a stage for fixing the display device 10_C may have a surface of an embossing structure, and as the front surface of the display device 10_C rubs against a surface of the stage, a scratch may occur on the front surface of the display device 10_C. The scratch may cause a short circuit defect.

In addition, in a process of forming the first to third via layers VIA1 to VIA3 of the step structure, the first and second via layers VIA1 and VIA2 may recede, and the first data line DL1 (or the outermost line) which is the second source metal layer SDL2 may be exposed. For example, in a process of etching (for example, dry etching) the third via layer VIA3 which is an organic layer, the second via layer VIA2 exposed by the third via layer VIA3 may also be etched, an edge of the second via layer VIA2 may recede in the first direction DR1, and the second source metal layer SDL2 may be exposed by the second via layer VIA2. In this case, a short circuit may occur between the second source metal layer SDL2 and the second power line PL2, and the pixels connected to the first data line DL1 may not emit light normally.

Even though the second source metal layer SDL2 is not exposed by the second via layer VIA2, because the second via layer VIA2 does not sufficiently cover the second source metal layer SDL2, a short circuit between the first data line DL1 and the second power line PL2 may occur due to the scratch.

A large number of residues RES (that is, the residues RES of the source metal layer) may occur near the edge of the first to third via layers VIA1 to VIA3, adjacent residues RES may be connected to each other, and the residues RES may exist in a line shape entirely. Because one residue RES is in a floating state, the one residue RES may not be a problem even though the one residue RES contacts the second power line PL2. However, the residue RES having the line shape entirely may cause a short circuit while connecting the second power line PL2 to another configuration.

Therefore, the first to third via layers VIA1 to VIA3 of the display device 10 according to one or more embodiments may have the clad structure, and the second via layer VIA2 and/or the third via layer VIA3 may cover the lower residue RES.

As described above, when the first to third via layers VIA1 to VIA3 have the step structure, a short circuit may occur in the second source metal layer SDL2 and/or the third source metal layer SDL3. In one or more embodiments, when the first to third via layers VIA1 to VIA3 have the clad structure, a short circuit may not occur in the second source metal layer SDL2 and/or the third source metal layer SDL3.

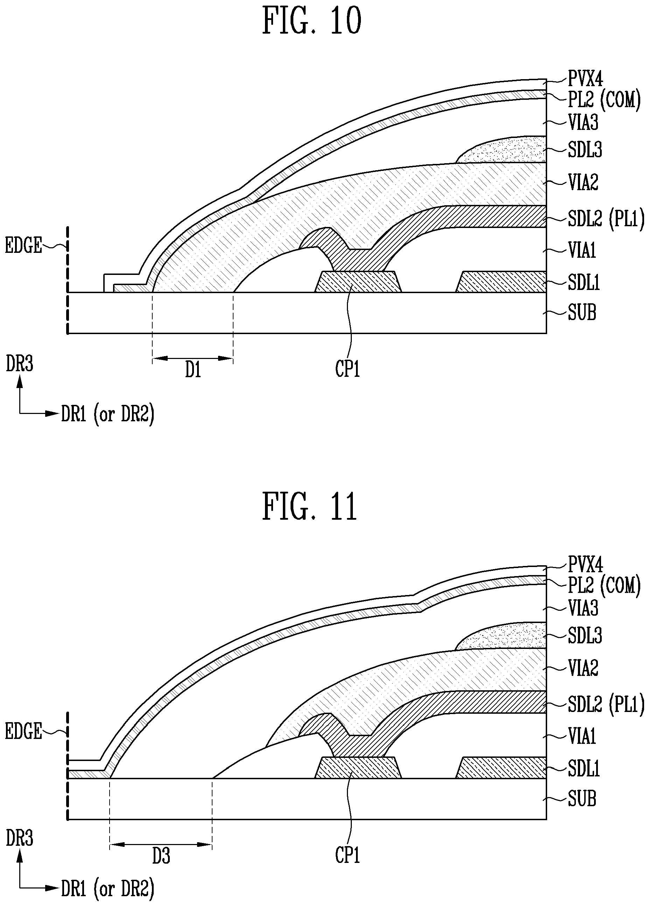

FIGS. 10 and 11 are cross-sectional views illustrating an embodiment of the display device of FIG. 1. In FIGS. 10 and 11, a cross-section of the outer portion of the display device 10 adjacent to the edge EDGE is briefly shown, in correspondence with the display device 10 of FIG. 8.

Referring to FIGS. 8, 10, and 11, except for a disposition of the second and third via layers VIA2 and VIA3, each of the embodiment of FIG. 10 and the embodiment of FIG. 11 may be substantially equal or similar to the display device of FIG. 8. Therefore, an overlapping description may not be repeated.

In one or more embodiments, the second via layer VIA2 may directly cover the first via layer VIA1, the third via layer VIA3 may not cover (e.g., may not completely cover) the second via layer VIA2, and the edge of the second via layer VIA2 may be exposed by the third via layer VIA3.

As shown in FIG. 10, the second via layer VIA2 may protrude or extend the most toward the edge EDGE of the substrate SUB, and the second via layer VIA2 may completely cover the first via layer VIA1 and the second source metal layer SDL2 (the first power line PL1, the data line, and the like). The second via layer VIA2 may further protrude or extend by the distance D1 of about 5 µm or more, for example, about 9 µm to about 10 µm, to cover the first via layer VIA1 and the second source metal layer SDL2. Therefore, a short circuit between the second source metal layer SDL2 and an upper metal layer (for example, the third source metal layer SDL3 and the second power line PL2) may be prevented.

Another organic layer (or organic structure) may not be disposed between the second via layer VIA2 and the edge EDGE in the first direction DR1.

The third via layer VIA3 may be positioned inside the first via layer VIA1, but is not limited thereto. For example, the third via layer VIA3 may protrude further than the first via layer VIA1 toward the edge EDGE.

Compared to the embodiment of FIG. 8, because only the second via layer VIA2 protrudes toward the edge EDGE than the first via layer VIA1, the minimum distance GHS1 (refer to FIG. 5) may be further reduced. That is, the dead space of the display device may be further reduced. The embodiment of FIG. 10 may be used when an outermost line most adjacent to the edge EDGE exists in the second source metal layer SDL2, but is not limited thereto.

In one or more embodiments, the second via layer VIA2 may not cover (e.g., may not completely cover) the first via layer VIA1, an edge portion of the first via layer VIA1 may be exposed by the second via layer VIA2 (e.g., see FIG. 11), and the third via layer VIA3 may directly cover the first via layer VIA1 (or an exposed portion of the first via layer VIA1).

As shown in FIG. 11, the third via layer VIA3 may protrude or extend the most toward the edge EDGE of the substrate SUB, and the third via layer VIA3 may completely cover not only the second via layer VIA2 and the third source metal layer SDL3 but also the first via layer VIA1 and the second source metal layer SDL2 (or the first power line PL1, the data line, and the like). The third via layer VIA3 may protrude or extend further than the first via layer VIA1 by a distance D3 of about 5 µm or more, for example, about 9 µm to about 10 µm, and may cover the first via layer VIA1 and the second via layer VIA2. Therefore, a short circuit between the second and third source metal layers SDL2 and SDL3 and an upper metal layer (for example, the second power line PL2) may be prevented.

Compared to the embodiment of FIG. 8, because only the third via layer VIA3 protrudes toward the edge EDGE than the first via layer VIA1, the minimum distance GHS1 (refer to FIG. 5) may be further reduced. That is, the dead space of the display device may be further reduced.

As described above, only a portion of the first to third via layers VIA1 to VIA3 may have the clad structure.

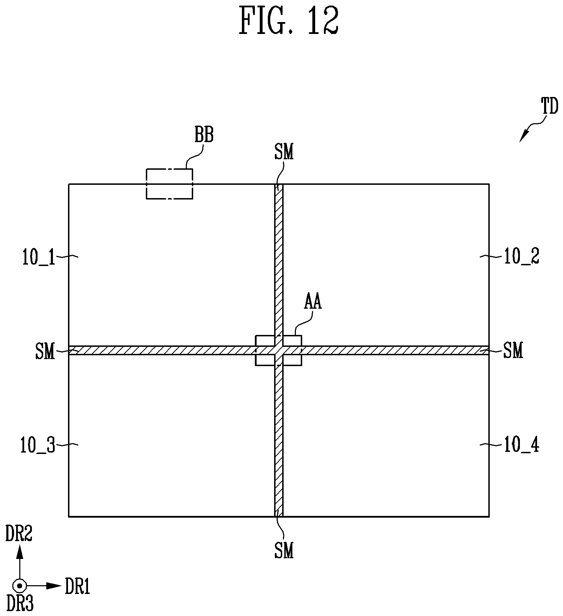

FIG. 12 is a perspective view illustrating a tiled display device including a plurality of display devices according to one or more embodiments.

Referring to FIG. 12, the tiled display device TD may include a plurality of display devices 10_1 to 10_4, and a seam SM. For example, the tiled display device TD may include a first display device 10_1, a second display device 10_2, a third display device 10_3, and a fourth display device 10_4.

The plurality of display devices 10_1 to 10_4 may be arranged in a grid shape. The plurality of display devices 10_1 to 10_4 may be arranged in a matrix form in M (M is a positive integer) number of rows and N (N is a positive integer) number of columns. For example, the first display device 10_1 and the second display device 10_2 may be adjacent to each other in the first direction DR1. The first display device 10_1 and the third display device 10_3 may be adjacent to each other in the second direction DR2. The third display device 10_3 and the fourth display device 10_4 may be adjacent to each other in the first direction DR1. The second display device 10_2 and the fourth display device 10_4 may be adjacent to each other in the second direction DR2.

However, the number and a disposition of the plurality of display devices 10_1 to 10_4 in the tiled display device TD are not limited to those shown in FIG. 12. The number and the disposition of the display devices 10_1 to 10_4 in the tiled display device TD may be determined according to a size of each of the display device 10 and the tiled display device TD and a shape of the tiled display device TD.

The plurality of respective display devices 10_1 to 10_4 may have the same size, but are not limited thereto. For example, the plurality of respective display devices 10_1 to 10_4 may have different sizes.

Each of the plurality of display devices 10_1 to 10_4 may have a rectangular shape including a long side and a short side. The plurality of display devices 10_1 to 10_4 may be disposed in a state in which the long sides or the short sides are connected to each other. Some or all of the plurality of display devices 10_1 to 10_4 may be disposed at an edge of the tiled display device TD and may form one side of the tiled display device TD. At least one display device from among the plurality of display devices 10_1 to 10_4 may be disposed at at least one corner of the tiled display device TD, and may form two adjacent sides of the tiled display device TD. At least one display device from among the plurality of display devices 10_1 to 10_4 may be surrounded by other display devices.

Each of the plurality of display devices 10_1 to 10_4 may be substantially the same as the display device 10 described in connection with FIGS. 1 to 8. Therefore, a description of each of the plurality of display devices 10_1 to 10_4 is omitted.

The seam SM may include a coupling member or an adhesive member. In this case, the plurality of display devices 10_1 to 10_4 may be connected to each other through the coupling member or the adhesive member of the seam SM. The seam SM may be disposed between the first display device 10_1 and the second display device 10_2, between the first display device 10_1 and the third display device 10_3, between the second display device 10_2 and the fourth display device 10_4, and between the third display device 10_3 and the fourth display device 10_4.

FIG. 13 is an enlarged view of an area AA of FIG. 12.

Referring to FIG. 13, the seam SM may have a planar shape of a crisscross, a cross, or a plus sign in a center area of the tiled display device TD in which the first display device 10_1, the second display device 10_2, the third display device 10_3, and the fourth display device 10_4 are adjacent to each other. The seam SM may be disposed between the first display device 10_1 and the second display device 10_2, between the first display device 10_1 and the third display device 10_3, between the second display device 10_2 and the fourth display device 10_4, and between the third display device 10_3 and the fourth display device 10_4.

The first display device 10_1 may include first pixels PX1 arranged in a matrix form along the first direction DR1 and the second direction DR2 to display an image. The second display device 10_2 may include second pixels PX2 arranged in a matrix form along the first direction DR1 and the second direction DR2 to display an image. The third display device 10_3 may include third pixels PX3 arranged in a matrix form along the first direction DR1 and the second direction DR2 to display an image. The fourth display device 10_4 may include fourth pixels PX4 arranged in a matrix form along the first direction DR1 and the second direction DR2 to display an image.

A minimum distance between the first pixels PX1 adjacent in the first direction DR1 may be defined as a first horizontal separation distance GH1, and a minimum distance between the second pixels PX2 adjacent in the first direction DR1 may be defined as a second horizontal separation distance GH2. The first horizontal separation distance GH1 and the second horizontal separation distance GH2 may be substantially the same.

The seam SM may be disposed between the first pixel PX1 and the second pixel PX2 adjacent in the first direction DR1. A minimum distance GG1 between the first pixel PX1 and the second pixel PX2 adjacent in the first direction DR1 may be a sum of a minimum distance GHS1 between the first pixel PX1 and the seam SM in the first direction DR1, a minimum distance GHS2 between the second pixel PX2 and the seam SM in the first direction DR1, and a width GSM1 of the seam SM in the first direction DR1.

The minimum distance GG1 between the first pixel PX1 and the second pixel PX2 adjacent in the first direction DR1, the first horizontal separation distance GH1, and the second horizontal separation distance GH2 may be substantially the same. To this end, the minimum distance GHS1 between the first pixel PX1 and the seam SM in the first direction DR1 may be less than the first horizontal separation distance GH1, and the minimum distance GHS2 between the second pixel PX2 and the seam SM in the first direction DR1 may be less than the second horizontal separation distance GH2. In addition, the width GSM1 of the seam SM in the first direction DR1 may be less than the first horizontal separation distance GH1 or the second horizontal separation distance GH2.

A minimum distance between the third pixels PX3 adjacent in the first direction DR1 may be defined as a third horizontal separation distance GH3, and a minimum distance between the fourth pixels PX4 adjacent in the first direction DR1 may be defined as a fourth horizontal separation distance GH4. The third horizontal separation distance GH3 and the fourth horizontal separation distance GH4 may be substantially the same.

The seam SM may be disposed between the third pixel PX3 and the fourth pixel PX4 adjacent in the first direction DR1. A minimum distance GG4 between the third pixel PX3 and the fourth pixel PX4 adjacent in the first direction DR1 may be a sum of a minimum distance GHS3 between the third pixel PX3 and the seam SM in the first direction DR1, a minimum distance GHS4 between the fourth pixel PX4 and the seam SM in the first direction DR1, and the width GSM1 of the seam SM in the first direction DR1.

The minimum distance GG4 between the third pixel PX3 and the fourth pixel PX4 adjacent in the first direction DR1, the third horizontal separation distance GH3, and the fourth horizontal separation distance GH4 may be substantially the same. To this end, the minimum distance GHS3 between the third pixel PX3 and the seam SM in the first direction DR1 may be less than the third horizontal separation distance GH3 and the minimum distance GHS4 between the fourth pixel PX4 and the seam SM in the first direction DR1 may be less than the fourth horizontal separation distance GH4. In addition, the width GSM1 of the seam SM in the first direction DR1 may be less than the third horizontal separation distance GH3 or the fourth horizontal separation distance GH4.

A minimum distance between the first pixels PX1 adjacent in the second direction DR2 may be defined as a first vertical separation distance GV1, and a minimum distance between the third pixels PX3 in the second direction DR2 may be defined as a third vertical separation distance GV3. The first vertical separation distance GV1 and the third vertical separation distance GV3 may be substantially the same.

The seam SM may be disposed between the first pixel PX1 and the third pixel PX3 adjacent in the second direction DR2. A minimum distance GG2 between the first pixel PX1 and the third pixel PX3 adjacent in the second direction DR2 may be a sum of a minimum distance GVS1 between the first pixel PX1 and the seam SM in the second direction DR2, a minimum distance GVS3 between the third pixel PX3 and the seam SM in the second direction DR2, and a width GSM2 of the seam SM in the second direction DR2.

The minimum distance GG2 between the first pixel PX1 and the third pixel PX3 adjacent in the second direction DR2, the first vertical separation distance GV1, and the third vertical separation distance GV3 may be substantially the same. To this end, the minimum distance GVS1 between the first pixel PX1 and the seam SM in the second direction DR2 may be less than the first vertical separation distance GV1, and the minimum distance GVS3 between the third pixel PX3 and the seam SM in the second direction DR2 may be less than the third vertical separation distance GV3. In addition, the width GSM2 of the seam SM in the second direction DR2 may be less than the first vertical separation distance GV1 or the third vertical separation distance GV3.

A minimum distance between the second pixels PX2 adjacent in the second direction DR2 may be defined as a second vertical separation distance GV2, and a minimum distance between the fourth pixels PX4 adjacent in the second direction DR2 may be defined as a fourth vertical separation distance GV4. The second vertical separation distance GV2 and the fourth vertical separation distance GV4 may be substantially the same.

The seam SM may be disposed between the second pixel PX2 and the fourth pixel PX4 adjacent in the second direction DR2. A minimum distance GG3 between the second pixel PX2 and the fourth pixel PX4 adjacent in the second direction DR2 may be a sum of a minimum distance GVS2 between the second pixel PX2 and the seam SM in the second direction DR2, a minimum distance GVS4 between the fourth pixel PX4 and the seam SM in the second direction DR2, and the width GSM2 of the seam SM in the second direction DR2.

The minimum distance GG3 between the second pixel PX2 and the fourth pixel PX4 adjacent in the second direction DR2, the second vertical separation distance GV2, and the fourth vertical separation distance GV4 may be substantially the same. To this end, the minimum distance GVS2 between the second pixel PX2 and the seam SM in the second direction DR2 may be less than the second vertical separation distance GV2, and the minimum distance GVS4 between the fourth pixel PX4 and the seam SM in the second direction DR2 may be less than the fourth vertical separation distance GV4. In addition, the width GSM2 of the seam SM in the second direction DR2 may be less than the second vertical separation distance GV2 or the fourth vertical separation distance GV4.

As shown in FIG. 13, the minimum distance between the pixels of the display devices adjacent to each other may be substantially the same as the minimum distance between the pixels of each of the display devices so that the seam SM is not visually recognized between images displayed by the plurality of display devices 10_1 to 10_4.

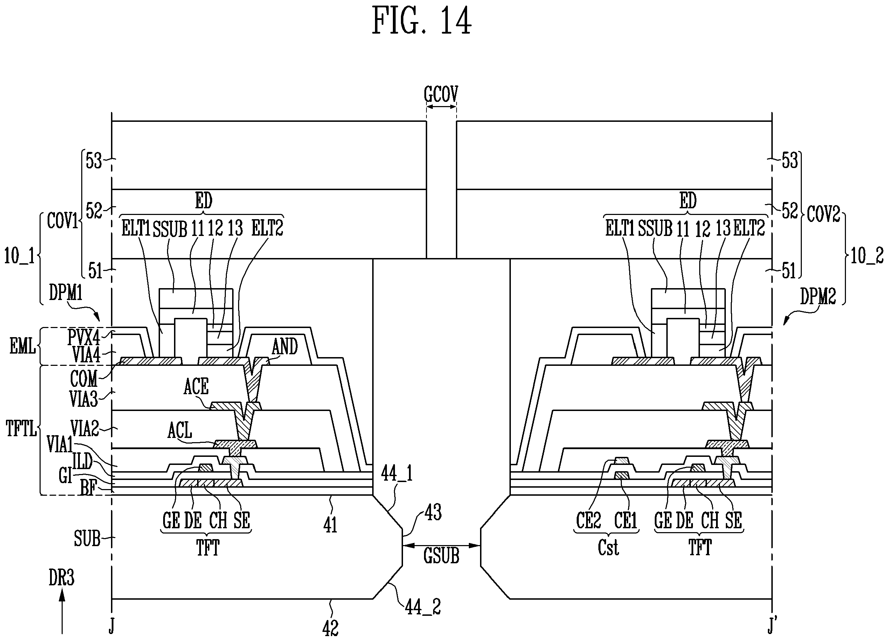

FIG. 14 is a cross-sectional view illustrating an example of a tiled display device taken along the line J-J' of FIG. 13.

Referring to FIG. 14, the first display device 10_1 may include a first display module DPM1 and a first front cover COV1. The second display device 10_2 may include a second display module DPM2 and a second front cover COV2.

Each of the first display module DPM1 and the second display module DPM2 may include the substrate SUB, the thin film transistor layer TFTL, and the light emitting element layer EML. The thin film transistor layer TFTL and the light emitting element layer EML have already been described in detail in connection with FIGS. 7 and 8. In a description of FIG. 14, a content overlapping that of FIGS. 7 and 8 is omitted.

The substrate SUB may include a first surface 41 on which the thin film transistor layer TFTL is disposed, a second surface 42 opposite the first surface 41, and a first side surface 43 disposed between the first surface 41 and the second surface 42. The first surface 41 may be a front surface or an upper surface of the substrate SUB, and the second surface 42 may be a rear surface or a lower surface of the substrate SUB.

In addition, the substrate SUB may further include chamfer surfaces 44_1 and 44_2 disposed between the first surface 41 and the first side surface 43 and between the second surface 42 and the first side surface 43. The thin film transistor layer TFTL and the light emitting element layer EML may not be disposed on the chamfer surfaces 44_1 and 44_2. The substrate SUB of the first display device 10_1 and the substrate SUB of the second display device 10_2 may be prevented from being collided with each other and damaged, by the chamfer surfaces 44_1 and 44_2.

The chamfer surfaces 44_1 and 44_2 may also be disposed between the first surface 41 and each of other side surfaces except for the first side surface 43 and between the second surface 42 and each of other side surfaces except for the first side surface 43. For example, when the first display device 10_1 and the second display device 10_2 have the planar shape of the rectangle as shown in FIG. 8, the chamfer surfaces 44_1 and 44_2 may be disposed between the first surface 41 and each of a second side surface, a third side surface, and a fourth side surface, and between the second surface 42 and each of the second side surface, the third side surface, and the fourth side surface.

The first front cover COV1 may be disposed on the chamfer surfaces 44_1 and 44_2 of the substrate SUB. That is, the first front cover COV1 may protrude beyond the substrate SUB in the first direction DR1 and the second direction DR2. Therefore, a distance GSUB between the substrate SUB of the first display device 10_1 and the substrate SUB of the second display device 10_2 may be greater than a distance GCOV between the first front cover COV1 and the second front cover COV2.

Each of the first front cover COV1 and the second front cover COV2 may include an adhesive member 51, a light transmittance adjustment layer 52 disposed on the adhesive member 51, and an anti-glare layer 53 disposed on the light transmittance adjustment layer 52.

The adhesive member 51 of the first front cover COV1 attaches the light emitting element layer EML of the first display module DPM1 to the first front cover COV1. The adhesive member 51 of the second front cover COV2 attaches the light emitting element layer EML of the second display module DPM2 to the second front cover COV2. The adhesive member 51 may be a transparent adhesive member capable of transmitting light. For example, the adhesive member 51 may be an optically clear adhesive film or an optically clear resin.

The anti-glare layer 53 may be designed to diffusely reflect external light in order to prevent external light from being directly reflected and visibility of an image from being deteriorated. Accordingly, a contrast ratio of images displayed by the first display device 10_1 and the second display device 10_2 may be increased by the anti-glare layer 53.

The light transmittance adjustment layer 52 may be designed to reduce a transmittance of external light or light reflected from the first display module DPM1 and the second display module DPM2. Accordingly, the distance GSUB between the substrate SUB of the first display module DPM1 and the substrate SUB of the second display module DPM2 may be prevented from being visually recognized from an outside.

The anti-glare layer 53 may be implemented as a polarizing plate, and the light transmittance adjustment layer 52 may be implemented as a phase retardation layer, but the present disclosure is not limited thereto.

In one or more embodiments, the light emitting element ED may be a light emitting structure including a first semiconductor layer 11, an active layer 12, a second semiconductor layer 13, a first contact electrode ELT1, and a second contact electrode ELT2. According to one or more embodiments, the light emitting element ED may further include a base substrate SSUB positioned at the uppermost portion. The base substrate may be a sapphire substrate, but is not limited thereto.

The first semiconductor layer 11 may be disposed on one surface of the base substrate SSUB and one surface of the active layer 12. The first semiconductor layer 11 may be formed of GaN doped with a p-type dopant such as Mg, Zn, Ca, Se, or Ba.

The active layer 12 may be disposed on a portion of one surface of the first semiconductor layer 11. The active layer 12 may include a material of a single or multiple quantum well structure. When the active layer 12 includes the material having the multiple quantum well structure, the active layer 12 may have a structure in which a well layer and a barrier layer are alternately stacked. At this time, the well layer may be formed of InGaN, and the barrier layer may be formed of GaN or AlGaN, but the present disclosure is not limited thereto. Alternatively, the active layer 12 may have a structure in which a type of semiconductor material having a large band gap energy and a semiconductor material having a small band gap energy are alternately stacked, and may also include group III to group V semiconductor materials different according to a wavelength band of emitted light.

When the active layer 12 includes InGaN, a color of emitted light may vary according to a content of indium (In). For example, as the content of indium (In) increases, a wavelength band of light emitted by the active layer 12 may move to a red wavelength band, and as the content of indium (In) decreases, the wavelength band of the light emitted by the active layer 12 may move to a blue wavelength band.

The second semiconductor layer 13 may be disposed on another surface of the active layer 12. For example, the second semiconductor layer 13 may be formed of GaN doped with an n-type conductive dopant such as Si, Ge, and/or Sn.

The first contact electrode ELT1 may be disposed on one surface of the first semiconductor layer 11, and the second contact electrode ELT2 may be disposed on one surface of the second semiconductor layer 13.

The second contact electrode ELT2 and the pixel electrode AND may be bonded to each other through a conductive adhesive member such as an anisotropic conductive film (ACF) or an anisotropic conductive paste (ACP). Alternatively, the second contact electrode ELT2 and the pixel electrode AND may be bonded to each other through a soldering process.

An example of a tiled display device taken along the line K-K', the line L-L', and the line M-M' of FIG. 13 is substantially the same as the example of the tiled display device taken along the line J-J' described in connection with FIG. 14, and thus a description thereof is omitted.

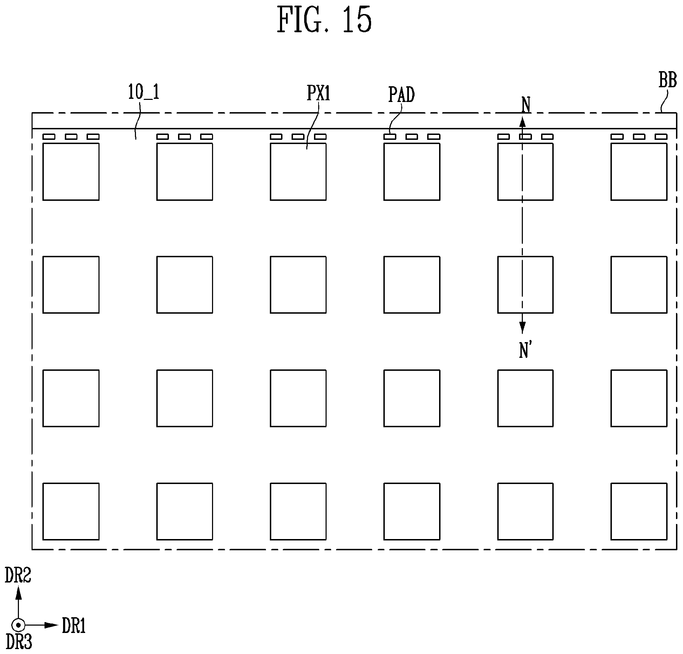

FIG. 15 is an enlarged view of an area BB of FIG. 12. For convenience of description, in FIG. 15, pads PAD and the first pixels PX1 disposed on an upper side of the first display device 10_1 are shown. Because the second display device 10_2, the third display device 10_3, and the fourth display device 10_4 have substantially the same configuration as the first display device 10_1, an overlapping description is omitted.

Referring to FIG. 15, the pads PAD may be disposed on an upper edge of the first display device 10_1. When the data line DL (refer to FIG. 5 or 16) of the first display device 10_1 extends in the second direction DR2, the pads PAD may be disposed at an upper edge and a lower edge of the first display device 10_1. Alternatively, when the data line of the first display device 10_1 extends in the first direction DR1, the pads PAD may be disposed at a left edge and a right edge of the first display device 10_1.

Each of the pads PAD may be connected to the data line on an upper surface of the substrate SUB. In addition, each of the pads PAD may be connected to a side surface line (refer to "SSL" of FIG. 16). The side surface line SSL may be disposed on an upper surface, one surface, and a lower surface (or a rear surface) of the substrate SUB. The side surface line SSL may be connected to a connection line (refer to "CCL" of FIG. 16) on the lower surface of the substrate SUB.

FIG. 16 is a cross-sectional view illustrating an example of a tiled display device taken along the line N-N' of FIG. 15. In FIG. 16, the same reference numerals are given to the same components as the cross-sectional view shown in FIGS. 7, 8, and 14, and an overlapping description is omitted.

Referring to FIG. 16, the pad PAD may be disposed on the interlayer insulating layer ILD. A portion of the pad PAD may be exposed without being covered by the fourth protective layer PVX4. The pad PAD may include the same material as the pixel electrode AND and the common electrode COM. For example, the pad PAD may include a metal material having a high reflectance such as a stack structure of aluminium and titanium (Ti/Al/Ti), a stack structure of aluminium and ITO (ITO/Al/ITO), an APC alloy, and/or a stack structure of an APC alloy and ITO (ITO/APC/ITO).

The first source metal layer SDL1 (refer to FIG. 7) may include the data line DL. The data line DL may be disposed on the gate insulating layer GI. The data line DL may be disposed on the same layer and may include the same material as the first capacitor electrode CE1. In contrast, the data line DL may be included in the first source metal layer SDL1 (refer to FIG. 7), may be disposed on the interlayer insulating layer ILD, and may include the same material as the second capacitor electrode CE2.

The pad PAD may be connected to the data line DL through a thirty-fifth contact hole CT35 passing through the interlayer insulating layer ILD.

The connection line CCL may be disposed on the lower surface of the substrate SUB. The connection line CCL may be a single layer or multiple layers formed of at least one of molybdenum (Mo), aluminium (Al), chromium (Cr), gold (Au), titanium (Ti), nickel (Ni), neodymium (Nd), and/or copper (Cu), and/or an alloy thereof.

A fifth via layer VIA5 may be disposed on a portion of the connection line CCL. The fifth via layer VIA5 may be formed of an organic layer such as acryl resin, epoxy resin, phenolic resin, polyamide resin, and/or polyimide resin.

A fifth protective layer PVX5 may be disposed on the fifth via layer VIA5. The fifth protective layer PVX5 may be formed of an inorganic layer, for example, a silicon nitride layer, a silicon oxy nitride layer, a silicon oxide layer, a titanium oxide layer, and/or an aluminium oxide layer.

The side surface line SSL may be disposed on an upper surface edge, a side surface, and a lower surface edge of the substrate SUB. One end of the side surface line SSL may be connected to the pad PAD. One end of the side surface line SSL may be connected to the pad PAD through a thirty-sixth contact hole CT36 passing through the fourth protective layer PVX4. Another end of the side surface line SSL may be connected to the connection line CCL. The side surface line SSL may connect the pad PAD formed on the upper surface edge of the substrate SUB and the connection line CCL formed on the lower surface edge of the substrate SUB.

The side surface line SSL may be disposed on the side surface of the substrate SUB, a side surface of the buffer layer BF, a side surface of the gate insulating layer GI, a side surface of the interlayer insulating layer ILD, and a side surface of the fourth protective layer PVX4.

In order to protect the externally exposed side surface line SSL from moisture and oxygen, and to prevent the side surface line SSL from being visually recognized to a user, a coating pattern surrounding an edge area of the display device 10_1 in which the side surface line SSL is disposed may be formed.

A flexible film FPCB may be disposed on a lower surface of the fifth protective layer PVX5. The flexible film FPCB may be connected to the connection line CCL through a thirty-seventh contact hole CT37 passing through the fifth via layer VIA5 and the fifth protective layer PVX5 using a conductive adhesive member CAM. A source driving circuit for supplying data voltages to the data lines DL may be disposed on a lower surface of the flexible film FPCB. The conductive adhesive member CAM may be an anisotropic conductive film or an anisotropic conductive paste.

As described above, in the first display device 10_1, the source driving circuit of the flexible film FPCB disposed on a lower portion of the substrate SUB may be connected to the data line DL through the connection line CCL, the side surface line SSL, and the pad PAD. That is, because the source driving circuit is disposed on the substrate SUB, a non-display area NDA may be eliminated, and thus the pixels PX may be formed at an edge of the substrate SUB.

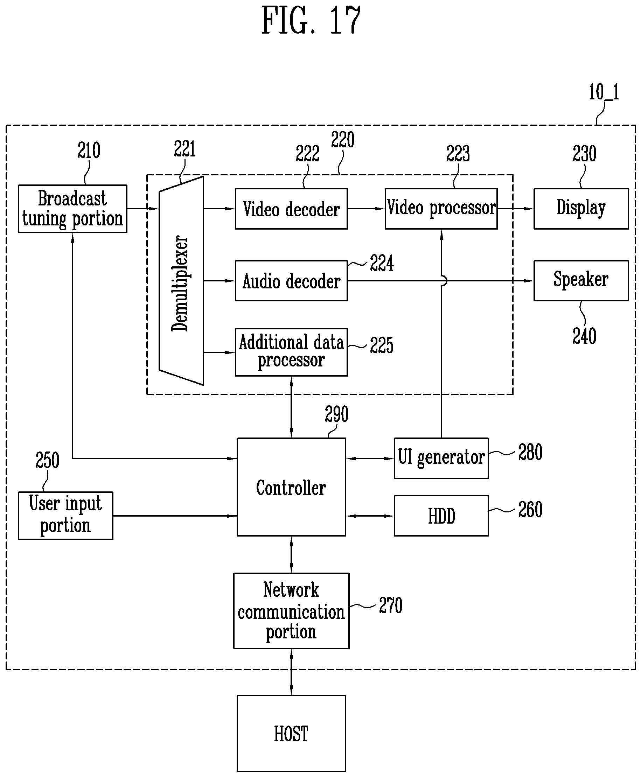

FIG. 17 is a block diagram illustrating a tiled display device according to one or more embodiments. In FIG. 17, the first display device 10_1 and a host system HOST are shown for convenience of description.

Referring to FIG. 17, the tiled display device TD according to one or more embodiments may include a host system HOST, a broadcast tuning unit 210, a signal processing unit 220, a display unit 230, a speaker 240, a user input unit 250, an HDD 260, a network communication unit 270, a UI generation unit 280, and a control unit 290 (or a controller).

The host system HOST may be implemented as any one of a television system, a home theater system, a set-top box, a navigation system, a DVD player, a Blu-ray player, a personal computer, a mobile phone system, and a tablet.

A user's instruction may be input to the host system HOST in various formats. For example, an instruction by a user's touch input may be input to the host system HOST. Alternatively, a user's instruction may be input to the host system HOST by a keyboard input or a button input of a remote controller.

The host system HOST may receive original video data corresponding to an original image from an outside. The host system HOST may divide the original video data by the number of display devices. For example, the host system HOST may divide the original video data into first video data corresponding to a first image, second video data corresponding to a second image, third video data corresponding to a third image, and fourth video data corresponding to a fourth image, in response to the first display device 10_1, the second display device 10_2, the third display device 10_3, and the fourth display device 10_4. The host system HOST may transmit the first video data to the first display device 10_1, transmit the second video data to the second display device 10_2, transmit the third video data to the third display device 10_3, and transmit the fourth video data to the fourth display device 10_4 (e.g., see FIG. 12).

The first display device 10_1 may display the first image according to the first video data, the second display device 10_2 may display the second image according to the second video data, the third display device 10_3 may display the third image according to the third video data, and the fourth display device 10_4 may display the fourth image according to the fourth video data. Accordingly, the user may view the original image in which the first to fourth images displayed on the first to fourth display devices 10_1, 10_2, 10_3, and 10_4 are combined (e.g., see FIG. 12).

The first display device 10_1 may include the broadcast tuning unit 210, the signal processing unit 220, the display unit 230, the speaker 240, the user input unit 250, the HDD 260, the network communication unit 270, the UI generation unit 280, and the control unit 290.

The broadcast tuning unit 210 may tune a suitable channel frequency (e.g., a predetermined channel frequency) under control of the control unit 290 and receive a broadcast signal of a corresponding channel through an antenna. The broadcast tuning unit 210 may include a channel detection module and an RF demodulation module.

A broadcast signal demodulated by the broadcast tuning unit 210 is processed by the signal processing unit 220 and output to the display unit 230 and the speaker 240. Here, the signal processing unit 220 may include a demultiplexer 221, a video decoder 222, a video processing unit 223, an audio decoder 224, and an additional data processing unit 225.

The demultiplexer 221 divides the demodulated broadcast signal into a video signal, an audio signal, and additional data. The divided video signal, audio signal, and additional data are restored by the video decoder 222, the audio decoder 224, and the additional data processing unit 225, respectively. At this time, the video decoder 222, the audio decoder 224, and the additional data processing unit 225 restore as a decoding format corresponding to an encoding format when the broadcast signal is transmitted.

In one or more embodiments, a decoded video signal is converted by the video processing unit 223 to fit a vertical frequency, resolution, a screen ratio, and the like corresponding to an output standard of the display unit 230, and a decoded audio signal is output to the speaker 240.

The display unit 230 may include a display panel on which an image is displayed, and a panel driver controlling driving of the display panel.

The user input unit 250 may receive a signal transmitted from the host system HOST. The user input unit 250 may be configured to receive data for selection and input of an instruction related to communication with other display devices by the user as well as data related to selection of a channel transmitted by the host system HOST, and selection and manipulation of a user interface (UI) menu.

The HDD 260 stores various software programs including an OS program, a recorded broadcast program, a moving picture, a photo, and other data, and may be formed of a storage medium such as a hard disk or a nonvolatile memory.

The network communication unit 270 is for short-range communication with the host system HOST and the other display devices, and may be implemented with a communication module including an antenna pattern that may implement mobile communication, data communication, Bluetooth, RF, Ethernet, and/or the like.

The network communication unit 270 may transmit and receive a wireless signal with at least one of a base station, an external terminal, and a server on a mobile communication network built according to technical standards or a communication method (for example, global system for mobile communication (GSM), code division multi access (CDMA), code division multi access 2000 (CDMA2000), enhanced voice-data optimized or enhanced voice-data only (EV-DO), wideband CDMA (WCDMA), high speed downlink packet access (HSDPA), high speed uplink packet access (HSUPA), long term evolution (LTE), long term evolution-advanced (LTE-A), 5G, or the like) for mobile communication through an antenna pattern to be described later.

The network communication unit 270 may transmit and receive a wireless signal in a communication network according to wireless Internet technologies through the antenna pattern to be described later. The wireless Internet technology includes, for example, wireless LAN (WLAN), wireless-fidelity (Wi-Fi), wireless fidelity (Wi-Fi) direct, digital living network alliance (DLNA), wireless broadband (WiBro), world interoperability for microwave access (WiMAX), high speed downlink packet access (HSDPA), high speed uplink packet access (HSUPA), long term evolution (LTE), long term evolution-advanced (LTE-A), and the like, and the antenna pattern transmits and receives data according to at least one wireless Internet technology within a range including an Internet technology which is not listed above.

The UI generation unit 280 generates a UI menu for communication with the host system HOST and the other display devices, and may be implemented by an algorithm code and an OSD IC. The UI menu for communication with the host system HOST and the other display devices DV2 to DV4 may be a menu for designating a counterpart digital TV for communication and selecting a desired function.

The control unit 290 is in charge of overall control of the first display device 10_1 and is in charge of communication control of the host system HOST and the second to fourth display devices 10_2, 10_3, and 10_4 (e.g., see FIG. 12), and a corresponding algorithm code for control is stored, and the control unit 290 may be implemented by a micro controller unit (MCU) in which the stored algorithm code is executed.

The control unit 290 controls to transmit a corresponding control instruction and data to the host system HOST and the second to fourth display devices 10_2, 10_3, and 10_4 through the network communication unit 270 according to an input and selection of the user input unit 250. Of course, when a suitable control instruction (e.g., a predetermined control instruction) and data are input from the host system HOST and the second to fourth display devices 10_2, 10_3, and 10_4 (e.g., see FIG. 12), an operation is performed according to the corresponding control instruction.

Because a block diagram of the second display device 10_2, a block diagram of the third display device 10_3, and a block diagram of the fourth display device 10_4 are substantially the same as the block diagram of the first display device 10_1 described in connection with FIG. 17, a description thereof is omitted.

Although the present disclosure has been described in detail in accordance with the above-described embodiments, it should be noted that the above-described embodiments are for the purpose of description and not of limitation. In addition, those skilled in the art may understand that various modifications are possible within the scope of the present disclosure.

## Claims

1. A display device comprising:
pixels spaced from each other by a first separation distance in a plan view, wherein each of the pixels comprises:
a transistor on a base layer;
a first organic layer on the transistor;
a second organic layer on the first organic layer;
a third organic layer on the second organic layer; and
a light emitting element on the third organic layer and electrically connected to the transistor,
wherein an outermost pixel that is nearest to an edge of the base layer among the pixels is spaced from the edge of the base layer by a distance within a second separation distance, the second separation distance being less than the first separation distance, and
wherein at least one of the second organic layer or the third organic layer clads the first organic layer near the edge of the base layer.

2. The display device according to claim 1, wherein in a plan view, the second organic layer or the third organic layer is extended by a distance equal to or greater than an average thickness of the first organic layer than the first organic layer toward the edge of the base layer.

3. The display device according to claim 1 or claim 2, wherein in a plan view, an organic structure is not located between the second organic layer or the third organic layer and the edge of the base layer.

4. The display device according to any one of claims 1 to 3, wherein the second organic layer is directly on the first organic layer, and the third organic layer is directly on the second organic layer, and
wherein an inorganic layer is not located between the first to third organic layers, optionally.

5. The display device according to claim 4, further comprising:
a first conductive pattern located between the first organic layer and the second organic layer;
a second conductive pattern located between the second organic layer and the third organic layer; and
a first pixel electrode located on the third organic layer,
wherein the light emitting element is electrically connected to the transistor through the first pixel electrode, the second conductive pattern, and the first conductive pattern, and
wherein a residue of the first conductive pattern is at an edge of the first organic layer, and the residue of the first conductive pattern is covered by the second organic layer or the third organic layer.

6. The display device according to claim 5, wherein:
(i) the display device further comprises:
a second pixel electrode on the third organic layer and an inorganic layer partially covering the second pixel electrode,
wherein in a cross-sectional view, the second pixel electrode overlaps the first conductive pattern and is spaced from the first conductive pattern by a distance equal to or greater than an average thickness of the second organic layer or the third organic layer; and/or
(ii) the first organic layer, the second organic layer, and the third organic layer comprise a same organic material.

7. The display device according to any one of claims 1 to 6, wherein an edge of the second organic layer or the third organic layer is in contact with a first surface of the base layer, and
wherein an angle between the edge of the second organic layer or the third organic layer and the first surface of the base layer is in a range of about 35 degrees to about 45 degrees.

8. The display device according to any one of claims 1 to 7, wherein:
(i) each of the pixels comprises a plurality of sub-pixels,
wherein each of the sub-pixels comprises the light emitting element in an emission area of the pixel, and
wherein, based on the emission area, the pixels are spaced from each other by the first separation distance, and the outermost pixel is spaced from the edge of the base layer by the distance within the second separation distance; and/or
(ii) the light emitting element is a flip chip type of micro light emitting diode element.

9. The display device according to any one of claims 1 to 8, wherein in a plan view, the second organic layer covers the first organic layer.

10. The display device according to claim 9, wherein:
(i) in a plan view, the third organic layer covers the second organic layer; or
(ii) the third organic layer does not cover the second organic layer, and an edge of the second organic layer is exposed by the third organic layer.

11. The display device according to claim 1 or claim 2, wherein an edge of the first organic layer is exposed by the second organic layer, and the third organic layer covers the edge of the first organic layer.

12. A tiled display device comprising:
a plurality of display devices and a seam located between the plurality of display devices,
wherein a first display device from among the plurality of display devices is a display device according to any one of claims 1 to 11.

13. The tiled display device according to claim 12, wherein:
(i) the light emitting element is a flip chip type of micro light emitting diode element; and/or
(ii) the base layer is a glass substrate.

14. The tiled display device according to claim 12 or claim 13, wherein the first display device further comprises:
a pad on a first surface of the base layer; and
a side surface line on the first surface of the base layer, a second surface opposite to the first surface, and one side surface between the first surface and the second surface, and connected to the pad, optionally wherein the first display device further comprises:
a connection line on the second surface of the base layer; and
a flexible film connected to the connection line through a conductive adhesive member, and
wherein the side surface line is connected to the connection line.

15. The tiled display device according to any one of claims 12 to 14, wherein the plurality of display devices are arranged in a matrix form in M rows and N columns.
